# EUROPEAN PATENT APPLICATION

(11) **EP 4 554 357 A1**
(43) Date of publication of application: **14.05.2025**
(21) Application number: 24210086.5
(22) Date of filing: 31.10.2024
(51) Int. Cl.: H10D 84/00, H10D 30/00, H10D 84/01, H10D 84/83, H10D 84/85, H10D 88/00

(54) **STACKED TRANSISTOR DEVICE HAVING CAPPING LAYER ON UPPER GATE MATERIAL, AND RELATED FABRICATION METHOD**

(30) Priority: 08.11.2023 US 202363597122 P; 10.11.2023 US 202363548052 P; 03.07.2024 US 202418763180
(71) Applicant: Samsung Electronics Co., Ltd., Suwon-si, Gyeonggi-do 16677 (KR)
(72) Inventor: YUN, Seungchan, San Jose, CA, 95134 (US); LEE, Jaehong, San Jose, CA, 95134 (US); YANG, Myung, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

Stacked field-effect transistor, FET devices are provided. A stacked FET device includes a lower FET (Tb) having lower channel layers (120b) and a lower gate material (170b) (e.g. a work-function metal, WFM, layer) that is between the lower channel layers (120b). The stacked FET device includes an upper FET (Ta) that is on top of the lower FET (Tb). The upper FET (Ta) has upper channel layers (120a) and an upper gate material (170a) (e.g. a WFM layer) that is between the upper channel layers (120a). Moreover, the stacked FET device includes an insulating capping layer (180) that is on the upper gate material (170a). Related methods of forming stacked FET devices are also provided.

## Description

### TECHNICAL FIELD

The present disclosure generally relates to the field of semiconductor devices and, more particularly, to three-dimensional transistor structures.

### BACKGROUND OF THE INVENTION

The size of transistors in integrated circuit (IC) devices has continued to decrease to down-scale logic elements. This has resulted in the development of gate-all-around (GAA) structures such as multi-bridge channel field-effect transistors (MBCFETs^{™}) and nanosheet FETs (NSFETs). Moreover, as technology to increase transistor density has continued to develop, three-dimensional device structures, such as stacked transistors, are under consideration.

A stacked transistor (or a "transistor stack") may include a first transistor and a second transistor. The first transistor may be a first type of transistor (e.g., an n-type metal-oxide-semiconductor (NMOS) transistor) and the second transistor may be a second type of transistor (e.g., a p-type metal-oxide-semiconductor (PMOS) transistor). The first and second types of transistors may be complementary to each other, and thus may be part of a complementary metal-oxide-semiconductor (CMOS) IC devices. The first transistor and second transistor may be stacked in any order (e.g., first transistor on top of second transistor, or second transistor on top of first transistor), thereby resulting in a stack comprising a top/upper transistor and a bottom/lower transistor.

### SUMMARY OF THE INVENTION

A stacked FET device, according to some embodiments herein, may include a lower FET having lower channel layers and a lower work-function metal (WFM) layer that is between the lower channel layers. The stacked FET device may include an upper FET that is on top of the lower FET. The upper FET may have upper channel layers and an upper WFM layer that is between the upper channel layers. Moreover, the stacked FET device may include an insulating capping layer that is on the upper WFM layer.

A stacked FET device, according to some embodiments herein, may include a lower FET having lower channel layers and a lower gate material that is between the lower channel layers. The stacked FET device may include an upper FET that is on top of the lower FET. The upper FET may include upper channel layers and an upper gate material that is between the upper channel layers. The stacked FET device may include an insulating capping layer that is in contact with the upper gate material. Moreover, the stacked FET device may include a gate-cut that is adjacent a side surface of the upper gate material.

A method of forming a stacked FET device, according to some embodiments herein, may include forming a nanosheet stack and a dummy gate structure on the nanosheet stack. The nanosheet stack may include lower channel layers and upper channel layers that are on the lower channel layers. The dummy gate structure may include a semiconductor sacrificial layer. The method may include etching the semiconductor sacrificial layer to expose sidewalls of the upper channel layers. The method may include forming a WFM on the exposed sidewalls of the upper channel layers and between the upper channel layers. The method may include forming an insulating capping layer on the WFM. Moreover, the method may include forming a gate-cut adjacent a side surface of the WFM.

### BRIEF DESCRIPTION OF THE DRAWINGS

FIG. 1A is a schematic block diagram of a transistor stack of a transistor device according to some embodiments herein.
FIG. 1B is a schematic block diagram of a gate-cut that is between two transistor stacks of the transistor device of FIG. 1A.
FIG. 1C is an example plan view of the transistor device of FIG. 1A.
FIG. 1D is an example cross-sectional view of the transistor device of FIG. 1C along the line A-A'.
FIG. 1E is an example cross-sectional view of the transistor device of FIG. 1C along the line B-B'.
FIGs. 1F and 1G are example cross-sectional views of the transistor device of FIG. 1C along the line C-C'.
FIGs. 2A-2Z are cross-sectional views illustrating operations of forming the transistor device of FIGs. 1C-1F.
FIGs. 3A-3AC are cross-sectional views illustrating operations that are modified relative to the operations of FIGs. 2A-2Z.
FIG. 4 is a flowchart corresponding to the operations shown in FIGs. 2A-2Z and 3A-3AC.

### DETAILED DESCRIPTION

Pursuant to embodiments herein, transistor devices are provided that include self-aligned gate-cuts. Each gate-cut is formed after forming an insulating capping layer on an upper gate material, such as an upper WFM. The upper gate material and the insulating capping layer can help the gate-cut to be self-aligned and can space the gate-cut apart from an adjacent transistor. Because the gate-cut is adequately-spaced from the adjacent transistor, the risk of damage to channel layers of the transistor when forming the gate-cut can be reduced, even if the gate-cut is misaligned. In contrast, misalignment of a gate-cut in a conventional transistor device may damage an adjacent transistor in the conventional transistor device. For example, the misaligned gate-cut in the conventional transistor device may be so close to the transistor that its formation (e.g., an etch operation/process for forming the gate-cut) damages a channel layer, or other layer, of the transistor.

In some embodiments herein, a transistor device may include stacked transistors having nanosheets. As the pitch of a gate and the pitch of nanosheets continue to down-scale, it may be difficult to implement a gate-cut separating adjacent stacked transistors. As an example, the space (e.g., lateral distance) between a gate-cut and nanosheets of a stacked transistor may decrease as the pitch of the nanosheets is scaled down, thereby increasing the risk of damaging (e.g., recessing) the nanosheets during formation of the gate-cut. According to embodiments herein, however, a self-align technique may be implemented to form the gate-cut with sufficient spacing from the stacked transistor to limit (e.g., prevent) damage to the nanosheets.

Example embodiments will be described in greater detail with reference to the attached figures.

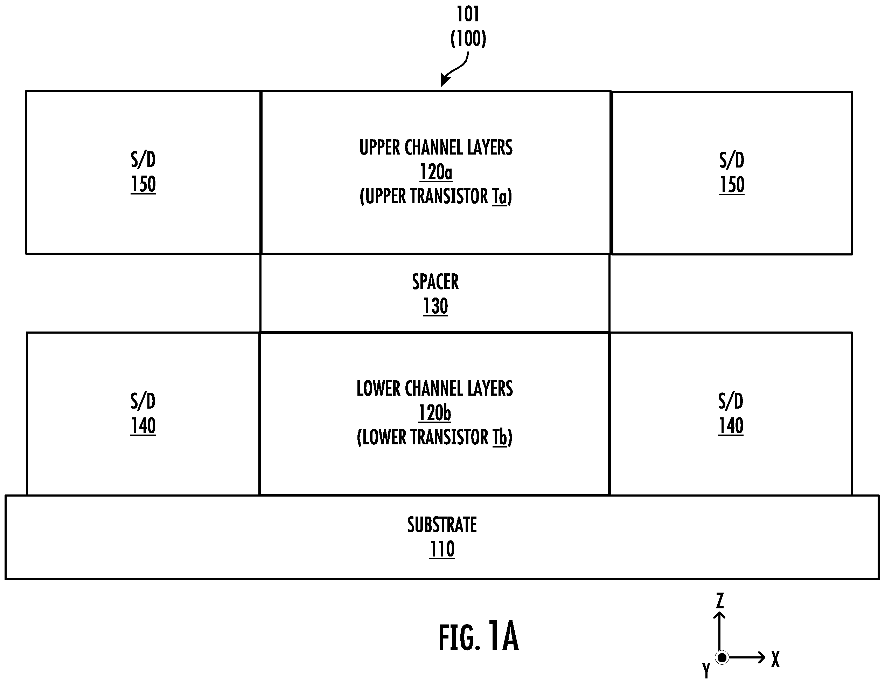

FIG. 1A is a schematic block diagram of a transistor stack 101 of a transistor device 100 according to some embodiments herein. The transistor stack 101 includes a lower transistor Tb having a stack of lower semiconductor channel layers 120b and an upper transistor Ta having a stack of upper semiconductor channel layers 120a. The upper semiconductor channel layers 120a and the lower semiconductor channel layers 120b may comprise, for example, silicon and may be free of germanium and carbon. The lower transistor Tb is between, in a vertical direction Z, the upper transistor Ta and a substrate 110 (e.g., a silicon, or other semiconductor, substrate). Moreover, an isolation layer/region 130, such as a middle dielectric isolation (MDI) layer/region, may, in some embodiments, serve as a spacer between the lower and upper transistors Ta, Tb. The isolation layer/region 130 may thus be referred to herein as a "spacer."

The lower channel layers 120b of the lower transistor Tb are between, in a first horizontal (i.e., lateral) direction X, a pair of lower source/drain (S/D) regions 140 that are electrically connected to the lower channel layers 120b. The first horizontal direction X and the vertical direction Z may be perpendicular to each other, and a second horizontal (i.e., lateral) direction Y may be perpendicular to each of the first horizontal direction X and the vertical direction Z. Each lower channel layer 120b may be implemented by, for example, a nanosheet or nanowire between the lower S/D regions 140. Likewise, the upper channel layers 120a of the upper transistor Ta may be between, in the first horizontal direction X, a pair of upper S/D regions 150 that are electrically connected to the upper channel layers 120a, and each upper channel layer 120a may be implemented by, for example, a nanosheet or nanowire between the upper S/D regions 150.

In some embodiments, the upper S/D regions 150 may include a different semiconductor material from that of the lower S/D regions 140. As an example, the upper S/D regions 150 may include silicon germanium, and the lower S/D regions 140 may include silicon carbide, or vice versa. In other embodiments, the upper S/D regions 150 may include the same semiconductor material as the lower S/D regions 140.

For simplicity of illustration, only one transistor stack 101 is shown in FIG. 1A. According to some embodiments, however, the transistor device 100 may include two, three, four, or more transistor stacks 101.

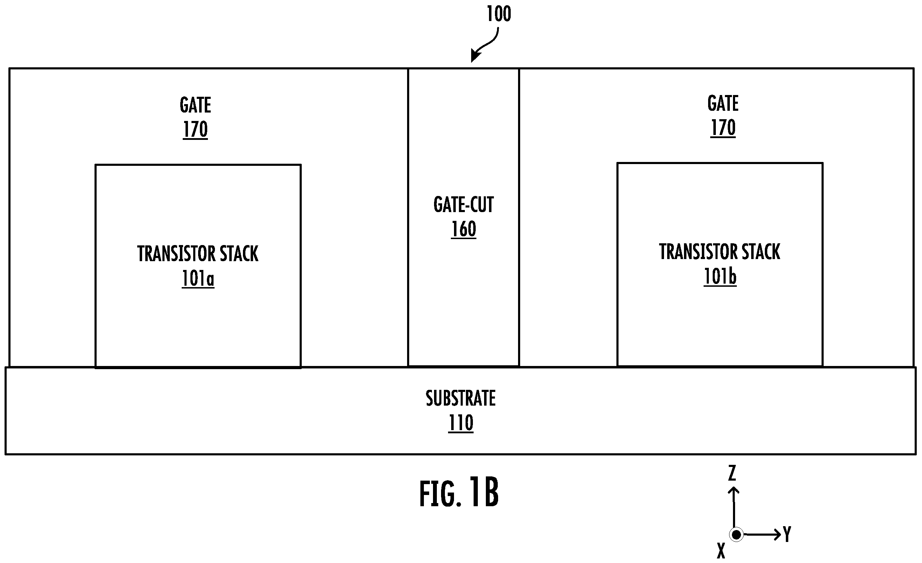

FIG. 1B is a schematic block diagram of a gate-cut 160 that is between two transistor stacks 101a, 101b of the transistor device 100 of FIG. 1A. The gate-cut 160 is on the substrate 110, and is adjacent each of the transistor stacks 101a, 101b. As used herein with respect to the gate-cut 160 and the transistor stacks 101a, 101b that are on opposite sides of the gate-cut 160, the term "adjacent" means that no other transistor stack 101 intervenes between the gate-cut 160 and the transistor stacks 101a, 101b. Moreover, as used herein with respect to a sidewall of the gate-cut 160 and a side surface of an upper gate material (e.g., an upper WFM) of one of the transistor stacks 101a, 101b, the term "adjacent" means that the sidewall of the gate-cut 160 is closer to the one of the transistor stacks 101a, 101b than to the other of the transistor stacks 101a, 101b.

The transistor stack 101a is the transistor stack 101 of FIG. 1A, and is labelled as "101a" in FIG. 1B to differentiate it from the transistor stack 101b. As shown in FIG. 1B, a first gate 170 is on the transistor stack 101a, and a second gate 170 is on the transistor stack 101b. The gate-cut 160 comprises an insulating material (e.g., silicon nitride) that electrically isolates the two gates 170 from each other. The gates 170 may each comprise one or more conductive materials, such as one or more WFMs.

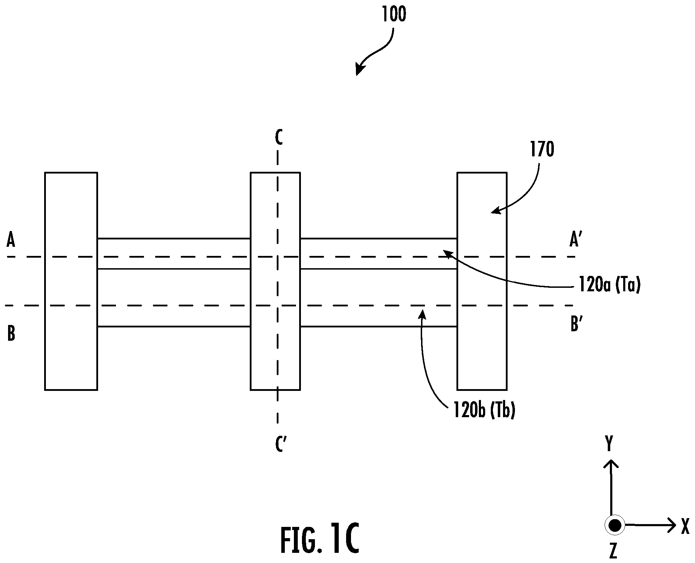

FIG. 1C is an example plan view of the transistor device 100. As shown in FIG. 1C, the transistor device 100 includes one or more gates 170 on the upper channel layers 120a of the upper transistor Ta and the lower channel layers 120b of the lower transistor Tb. A line A-A' extends along a channel length of the upper channel layers 120a of the upper transistor Ta in the first horizontal direction X. A line B-B' extends along a channel length of the lower channel layers 120b of the lower transistor Tb in the first horizontal direction X. The lines A-A' and B-B' are spaced apart from each other in the second horizontal direction Y. A line C-C' passes lengthwise (i.e., longitudinally) through a gate 170 in the second horizontal direction Y.

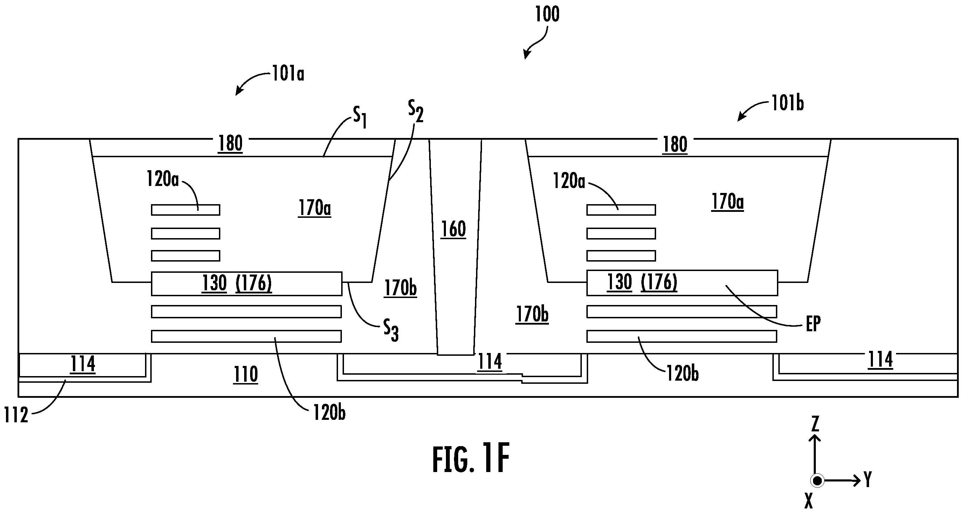

For simplicity of illustration, FIG. 1C shows the line C-C' passing through only one transistor stack 101 (FIG. 1A), which includes one upper transistor Ta and one lower transistor Tb. In some embodiments, however, the line C-C' may be extended to pass two transistor stacks 101a, 101b, as shown in FIGs. 1F, 1G, 2Y, 2Z, 3AB, and 3AC.

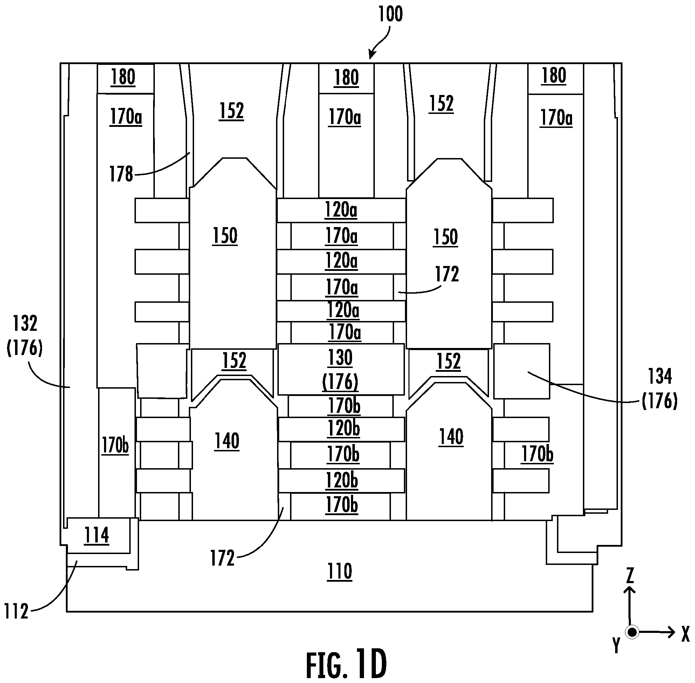

FIG. 1D is an example cross-sectional view of the transistor device 100 along the line A-A' of FIG. 1C. As shown in FIG. 1D, an upper gate 170a may be on the upper channel layers 120a of the upper transistor Ta of the transistor stack 101 (FIG. 1A), and a lower gate 170b may be on the lower channel layers 120b of the lower transistor Tb (FIG. 1B) of the transistor stack 101. The upper gate 170a is an upper conductive gate (e.g., an upper WFM layer) that may be between (in the vertical direction Z) the upper channel layers 120a, and may be spaced apart from the upper S/D regions 150 in the direction X by insulating spacers 172. The insulating spacers 172 may be on sidewalls of the upper gate 170a and between, in the vertical direction Z, the upper channel layers 120a.

Likewise, the lower gate 170b is a lower conductive gate (e.g., a lower WFM layer) that may be between (in the vertical direction Z) the lower channel layers 120b. The lower gate 170b may be spaced apart from the lower S/D regions 140 in the direction X by insulating spacers 172, which may be on sidewalls of the lower gate 170b and between, in the vertical direction Z, the lower channel layers 120b. In some embodiments, the insulating spacers 172 may contact the lower S/D regions 140, the upper S/D regions 150, sidewalls of the lower gate 170b, and sidewalls of the upper gate 170a. Sidewalls of the lower channel layers 120b may contact the lower S/D regions 140, and sidewalls of the upper channel layers 120a may contact the upper S/D regions 150.

The upper gate 170a and the lower gate 170b may each include a metal or a semiconductor material. As an example, the upper gate 170a and the lower gate 170b may comprise different metals, respectively. In some embodiments, the metals may be different WFMs, respectively. For example, the lower gate 170b may comprise a lower WFM layer that comprises aluminum, as the lower transistor Tb (FIG. 1A) may be an NMOS transistor, and the upper gate 170a may comprise an upper WFM layer of titanium nitride, as the upper transistor Ta (FIG. 1A) may be a PMOS transistor. Moreover, tungsten (or another metal) may be formed on the lower WFM layer and/or the upper WFM layer. Accordingly, the lower gate 170b may comprise the lower WFM layer and tungsten (or another metal), and the upper gate 170a may comprise the upper WFM layer and tungsten (or another metal).

According to some embodiments, the insulating spacers 172 may comprise, for example, nitrogen (e.g., silicon nitride). The insulating spacers 172 may also be referred to herein as "inner spacers," as they may be situated between nanosheet/nanowire channels within a transistor.

The upper and lower transistors Ta, Tb may be different types of MOSFETs. The transistor device 100 may thus be a stacked FET device. For example, the upper and lower transistors Ta, Tb may be PMOS and NMOS transistors, respectively, or vice versa. As an example, PMOS and NMOS transistors may be provided by S/D regions comprising silicon germanium and silicon carbide, respectively. In some embodiments, the spacer 130 may separate the lower channel layers 120b of the lower transistor Tb from the upper channel layers 120a of the upper transistor Ta. The spacer 130 may comprise, for example, silicon boron carbonitride (SiBCN).

For simplicity of illustration, a gate insulation layer is omitted from view in FIG. 1D. It will be understood, however, that a gate insulation layer may extend between each channel layer 120 and a gate 170. The gate insulation layer may wrap around each channel layer 120 and may be thinner than the spacer 130.

According to some embodiments, the first insulating layer 112 may be in a recess of the substrate 110. the second insulating layer 114 may also be in the recess, and may extend above the substrate 110 to, for example, a level of an uppermost surface of the upper gate 170a. The third insulating layer 152 may be between, in the vertical direction Z, the lower and upper S/D regions 140, 150. Moreover, the third insulating layer 152 may be on an upper surface of each of the upper S/D regions 150. The fourth insulating layer 132 may be on sidewalls of the gates 170a, 170b and on an upper surface of the second insulating layer 114, and the fifth insulating layer 134 may be between the upper gate 170a and the lower gate 170b. The sixth insulating layer 178 may be between the fourth insulating layer 132 and the third insulating layer 152, and between the fifth insulating layer 134 and the third insulating layer 152.

The insulating layers 132, 134 may comprise the same insulating material (e.g., SiBCN) as the spacer 130, and this insulating material may be different from an insulating material of the first insulating layer 112 and different from an insulating material of the insulating layers 114, 152. For example, the insulating layers 132, 134 and the spacer 130 may each be part of an insulating structure/layer 176 (i.e., the same insulating material). As an example, vertical portions of insulating material 176 may be provided by the fourth insulating layer 132, and lateral portions of the insulating material 176 may be provided by the spacer 130 and the fifth insulating layer 134. The spacer 130 may thus be referred to herein as a "lateral portion" of the insulating material 176, and the fourth insulating layer 132 may be referred to herein as a "vertical portion" (or "vertical portions") of the insulating material 176. In some embodiments, the first insulating layer 112 may comprise a different insulating material from that of the insulating layers 114, 152. As an example, the first insulating layer 112 may comprise a nitride (e.g., silicon nitride), and the insulating layers 114, 152 may each comprise an oxide (e.g., silicon oxide).

The transistor device 100 may include an insulating capping layer 180 that is on the upper gate 170a. For example, the insulating capping layer 180 may be on an upper surface of the upper gate 170a and/or on a side surface of the upper gate 170a. In some embodiments, the insulating capping layer 180 may be in contact with the upper surface of the upper gate 170a and/or in contact with the side surface of the upper gate 170a. The insulating capping layer 180 may be a relatively thin layer, and thus may be referred to herein as a "liner" layer. As an example, the insulating capping layer 180 may be thinner, in the direction Z, than the spacer 130.

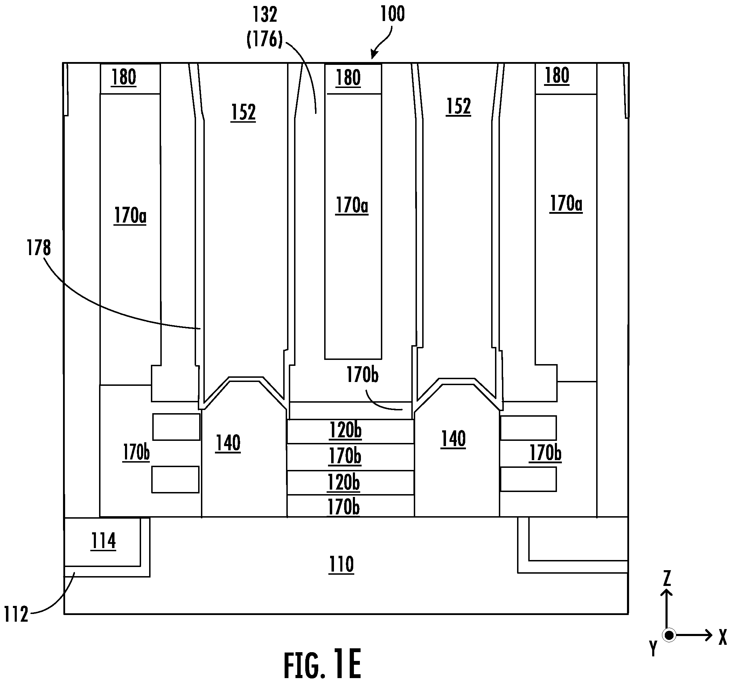

FIG. 1E is an example cross-sectional view of the transistor device 100 along the line B-B' of FIG. 1C. As shown in FIG. 1E, the insulating capping layer 180 may be on (e.g., in contact with) an upper surface of the upper gate 170a. The insulating capping layer 180 may comprise, for example, silicon nitride. In some embodiments, the insulating capping layer 180 may comprise the same insulating material (e.g., silicon nitride) as the gate-cut 160 (FIG. 1B).

For simplicity of illustration, insulating spacers 172 (FIG. 1D) are omitted from view in FIG. 1E. In some embodiments, however, the insulating spacers 172 may be present between the lower S/D regions 140 and the lower gate 170b in the cross-section shown in FIG. 1E.

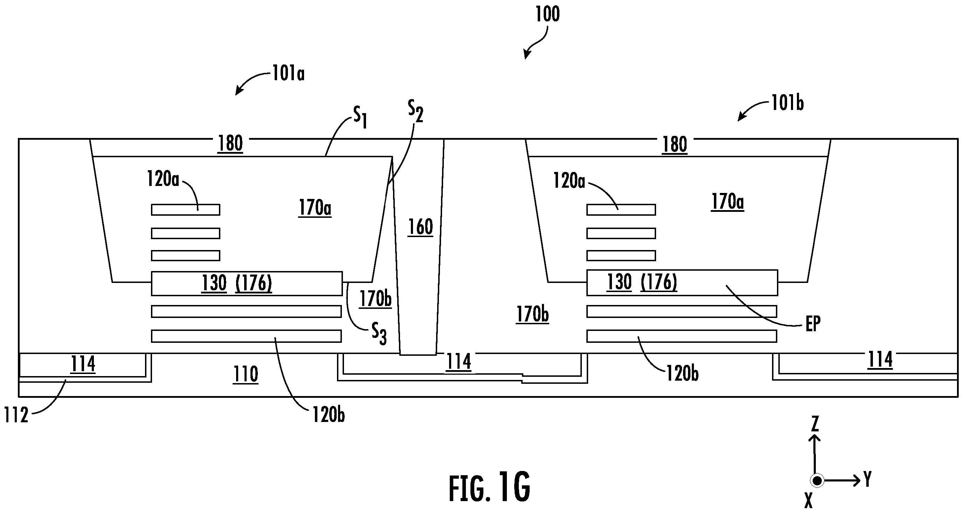

FIGs. 1F and 1G are example cross-sectional views of the transistor device 100 along the line C-C' of FIG. 1C. FIG. 1F shows an example in which the gate-cut 160 is spaced apart, in the second horizontal direction Y, from both the insulating capping layer 180 of the transistor stack 101a and the insulating capping layer 180 of the transistor stack 101b. Accordingly, the gate-cut 160 is not misaligned with respect to the transistor stacks 101a, 101b.

In contrast, FIG. 1G shows an example in which the gate-cut 160 is misaligned such that it is much closer, in the second horizontal direction Y, to the transistor stack 101a than to the transistor stack 101b. For example, the gate-cut 160 may be misaligned such that it is in contact with the insulating capping layer 180 of the transistor stack 101a. Even when the gate-cut 160 is misaligned with respect to the transistor stacks 101a, 101b, however, the insulating capping layer 180 may space the gate-cut 160 apart from channel layers 120 of the transistor stacks 101a, 101b such that the misaligned gate-cut 160 does not damage the transistor stacks 101a, 101b.

In some embodiments, the insulating capping layer 180 may be on an upper surface s₁ of the upper gate 170a of each of the of the transistor stacks 101a, 101b. For example, the insulating capping layer 180 may contact the entire width (in the second horizontal direction Y) of the upper surface s₁ of the upper gate 170a, as shown in the cross-sectional views of FIGs. 1F and 1G.

The gate-cut 160 (e.g., a sidewall thereof) may be adjacent, in the second horizontal direction Y, to a side surface s₂ of the upper gate 170a of (e.g., on) the transistor stack 101a. The lower gate 170b of (e.g., on) the transistor stack 101a may be between, in the second horizontal direction Y, the gate-cut 160 and the side surface s₂. As an example, the lower gate 170b may be in contact with both a sidewall of the gate-cut 160 and the side surface s₂ of the upper gate 170a. Moreover, a lower surface s₃ of the upper gate 170a may be wider, in the second horizontal direction Y, than the lower channel layers 120b that are vertically overlapped by the upper gate 170a. According to some embodiments, the lower surface s₃ may be on (e.g., in contact with) the spacer 130 and the lower gate 170b.

FIGs. 1F and 1G also show that the spacer 130 may include an extension portion EP that vertically overlaps the lower channel layers 120b and is not vertically overlapped by the upper channel layers 120a. The upper gate 170a and the insulating capping layer 180 may vertically overlap the extension portion EP. In some embodiments, the lower channel layers 120b (e.g., lower nanosheets) may be wider, in the second horizontal direction Y, than the upper channel layers 120a (e.g., upper nanosheets). For example, the lower channel layers 120b may be more than twice as wide as the upper channel layers 120a. According to some embodiments, the spacer 130 may have the same width as the lower channel layers 120b.

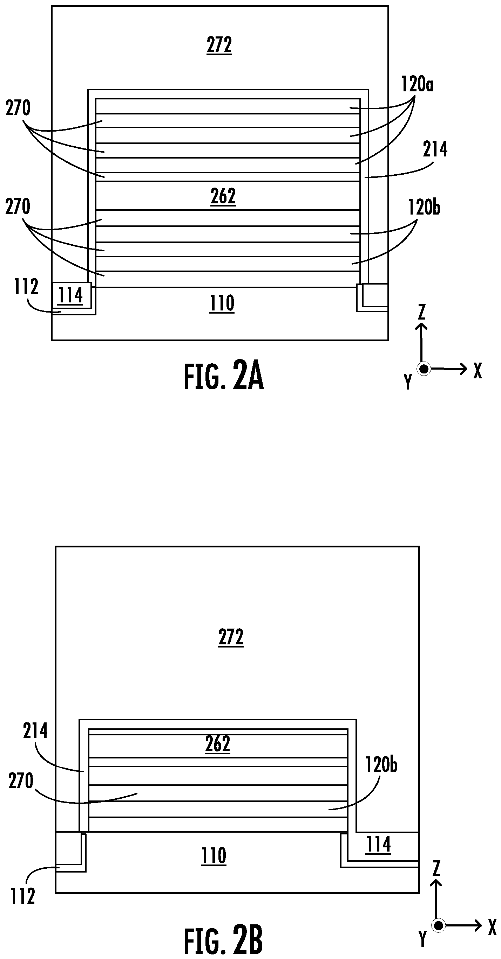

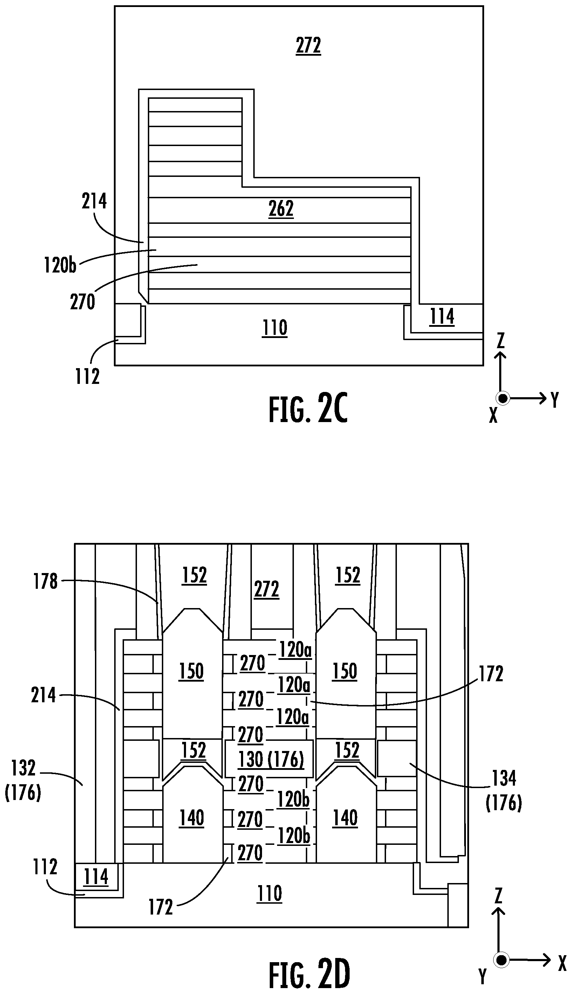

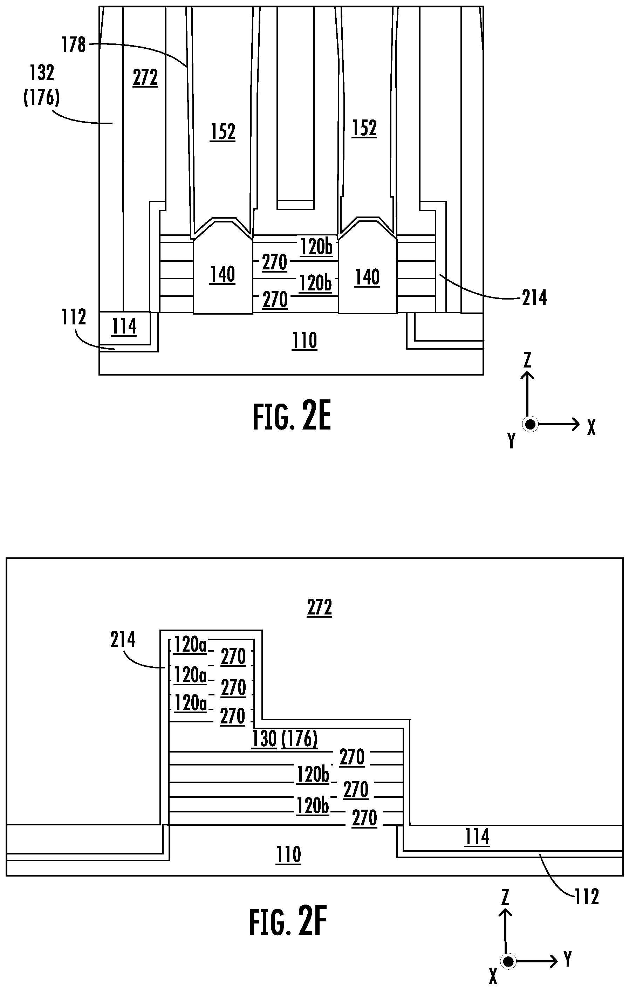

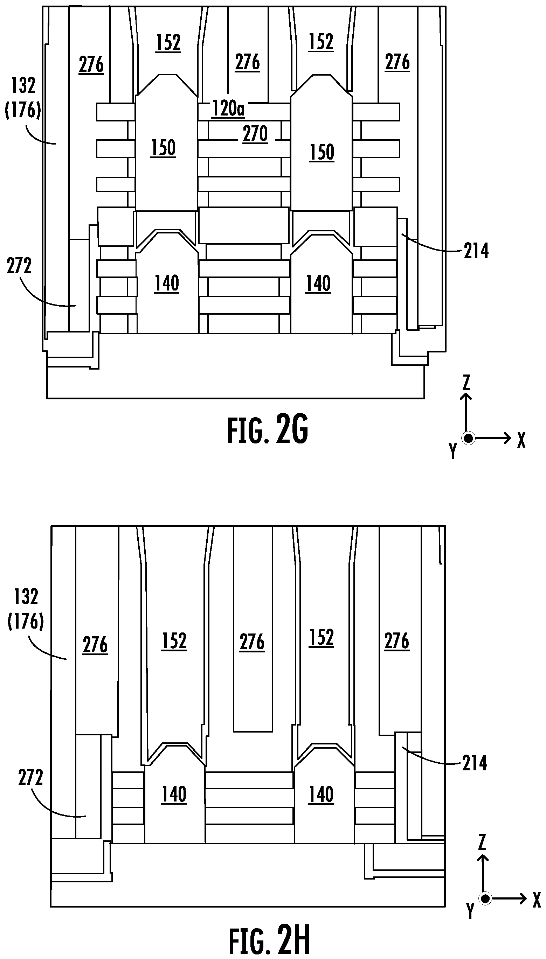

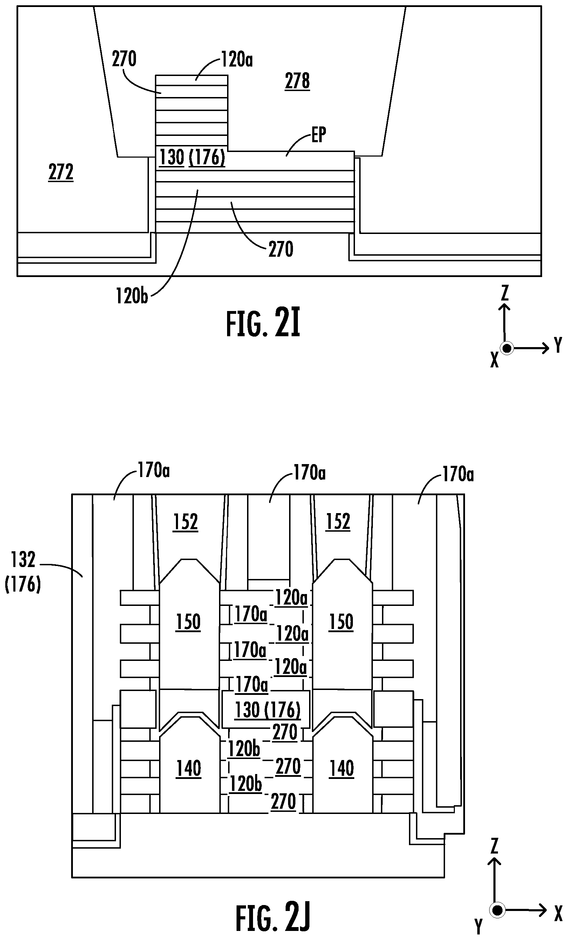

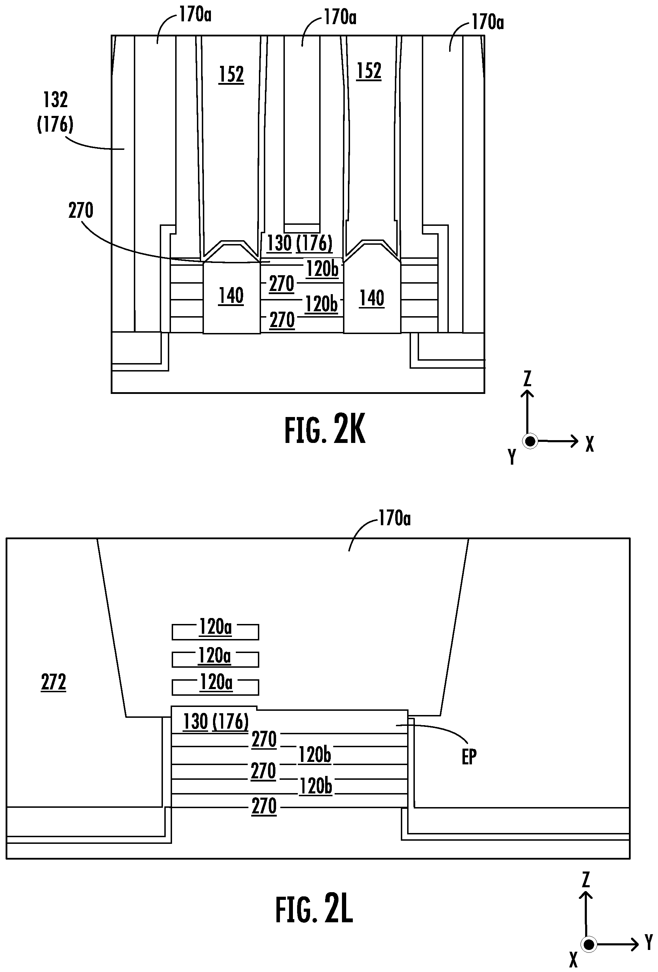

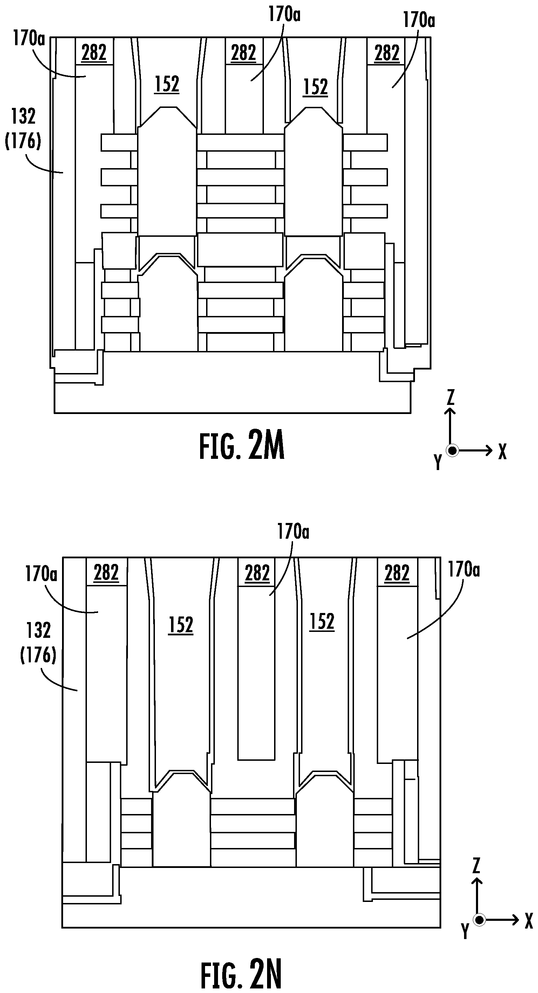

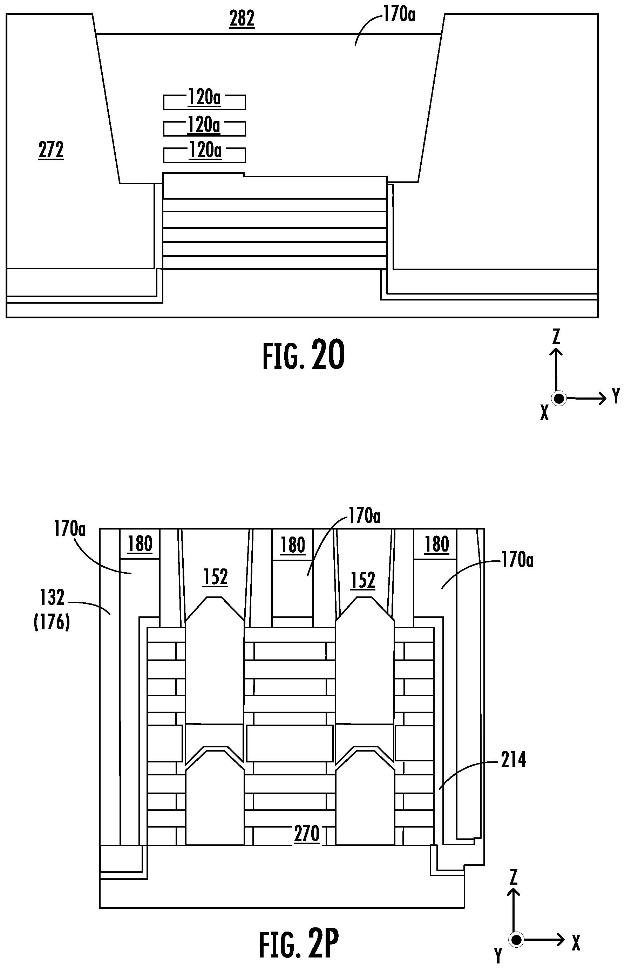

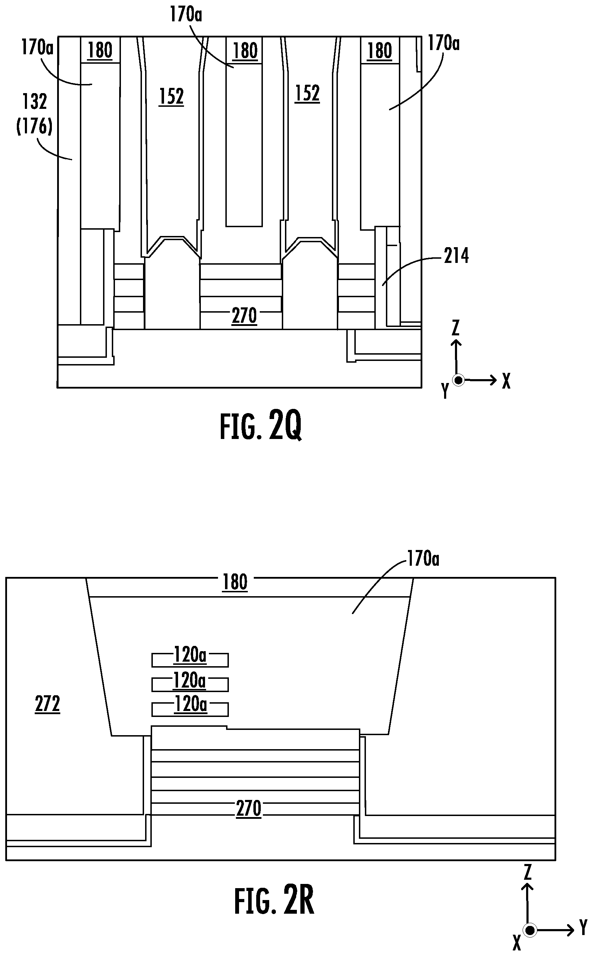

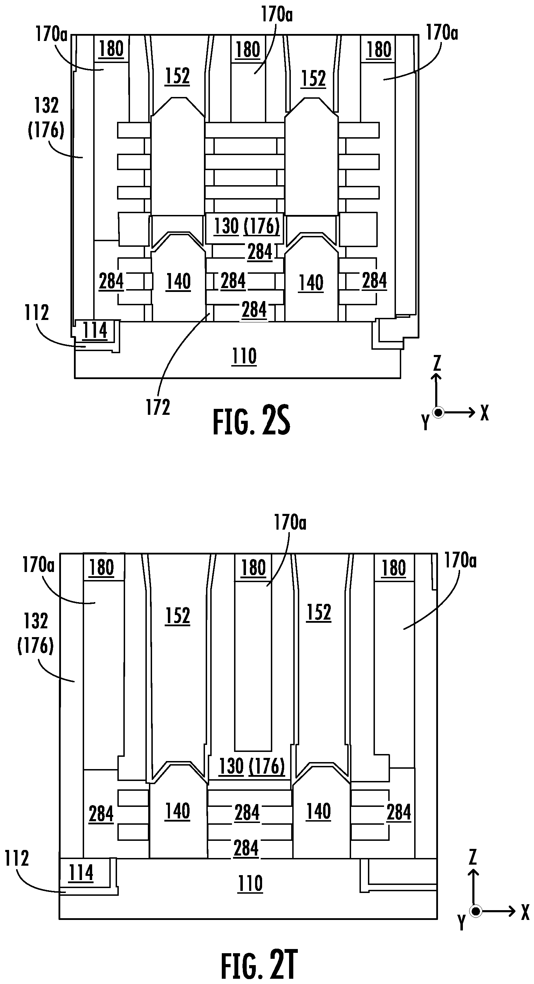

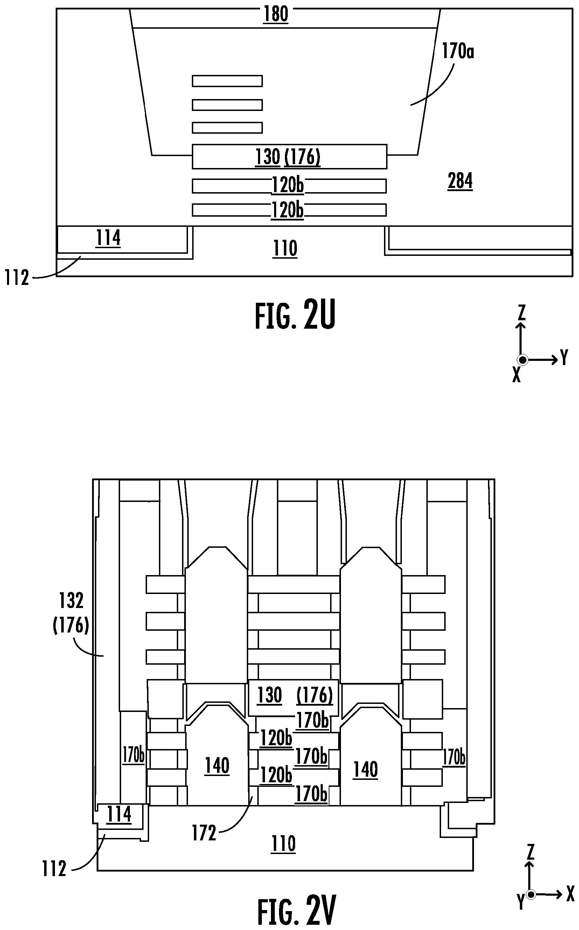

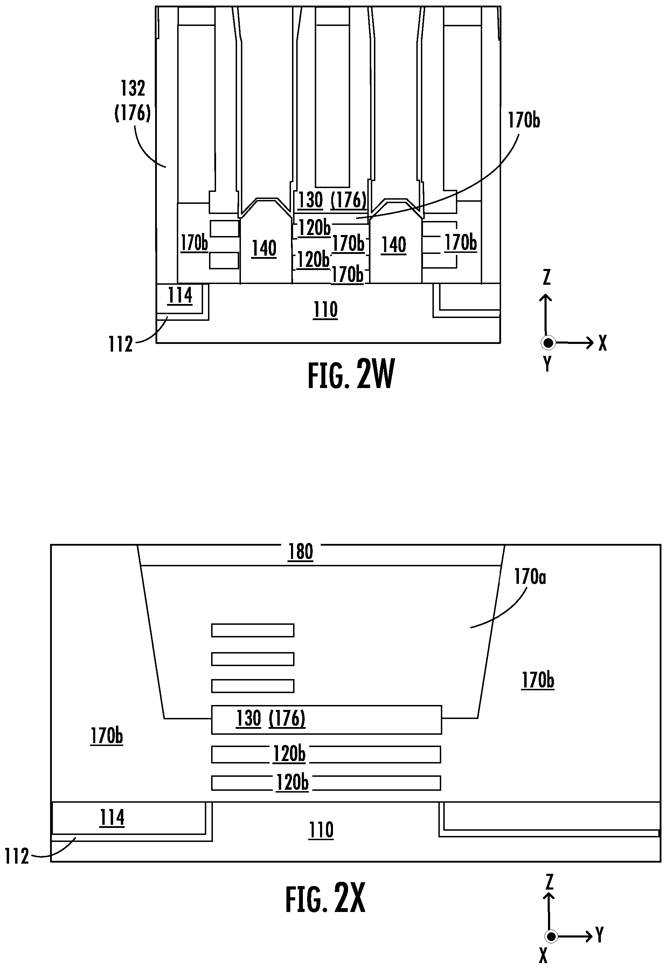

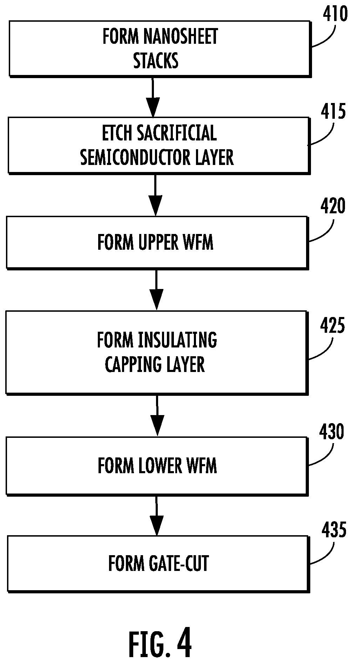

FIGs. 2A-2Z are cross-sectional views illustrating operations of forming the transistor device 100 of FIGs. 1C-1F, and FIG. 4 is a flowchart corresponding to the operations shown in FIGs. 2A-2Z. FIGs. 2A, 2D, 2G, 2J, 2M, 2P, 2S, and 2V are cross-sectional views corresponding to the line A-A' of FIG. 1C. FIGs. 2B, 2E, 2H, 2K, 2N, 2Q, 2T, and 2W are cross-sectional views corresponding to the line B-B' of FIG. 1C. Moreover, FIGs. 2C, 2F, 2I, 2L, 2O, 2R, 2U, and 2X-2Z are cross-sectional views corresponding to the line C-C' of FIG. 1C.

As shown in FIGs. 2A-2C and 4, the operations of forming the transistor device 100 may include forming (Block 410) stacks of semiconductor channel layers 120 on a substrate 110. In some embodiments, the channel layers 120 may be nanosheets, and the stacks may thus be nanosheet stacks. A lower stack comprises lower channel layers 120b, and an upper stack comprises upper channel layers 120a. The lower stack is separated from the upper stack by a sacrificial isolation layer 262. Moreover, sacrificial gate layers 270 may be alternately stacked on the substrate 110 with the channel layers 120. The sacrificial isolation layer 262 may be between upper ones of the sacrificial gate layers 270 and lower ones of the sacrificial gate layers 270.

The upper stack and the lower stack each form part of a transistor stack 101 (FIG. 1A). The lower channel layers 120b form part of a lower transistor Tb (FIG. 1A) of the transistor stack 101, and the upper channel layers 120a form part of an upper transistor Ta (FIG. 1A) of the transistor stack 101.

Though the plural term "stacks" is used in some examples herein for ease of differentiating between upper and lower ones of the channel layers 120, the singular term "stack" may also be used to describe the collective structure, as the upper channel layers 120a are stacked on top of the lower channel layers 120b. Accordingly, the term "nanosheet stack" may refer to either (i) a stack that includes both the upper channel layers 120a and the lower channel layers 120b, or (ii) a stack that includes one of only the upper channel layers 120a or only the lower channel layers 120b and is stacked with another stack that includes the other one of only the upper channel layers 120a or only the lower channel layers 120b.

The channel layers 120 are semiconductor layers that comprise, for example, silicon (e.g., polysilicon). In a subsequent process/operation, the sacrificial gate layers 270 may be replaced with an upper gate 170a and a lower gate 170b (FIG. 1D). Moreover, the sacrificial isolation layer 262 may be replaced with a spacer/MDI layer 130 (FIG. 1D) in a subsequent process/operation. The sacrificial gate layers 270 may comprise, for example, silicon germanium. Accordingly, the sacrificial gate layers 270 may have an etch selectivity relative to the channel layers 120. The sacrificial gate layers 270 may also have an etch selectivity relative to the sacrificial isolation layer 262. For example, the sacrificial isolation layer 262 and the sacrificial gate layers 270 may each comprise silicon germanium, but with different concentrations of germanium. As an example, the sacrificial isolation layer 262 may have a higher concentration of germanium (e.g., 55%) than the sacrificial gate layers 270 (e.g., 25%).

In some embodiments, the seventh insulating layer 214 may be formed on sidewalls of the alternately-stacked channel layers 120 and sacrificial gate layers 270, and on an uppermost surface of an uppermost one of the upper channel layers 120a. Moreover, a first insulating layer 112 may be formed in a recess of the substrate 110, and the second insulating layer 114 may be formed in the recess on top of the insulating layer 112. The insulating layers 114, 214 may comprise the same insulating material (e.g., an oxide), and may, in some embodiments, be a single, continuous layer having no interface or separation between the insulating layers 114, 214. The insulating material of the insulating layers 114, 214 may be different from that of the insulating layer 112, which may comprise, for example, a nitride (e.g., silicon nitride).

A dummy gate structure may be formed on the channel layers 120. The dummy gate structure may include a sacrificial layer 272, which will be replaced with gates 170a, 170b (FIG. 1F) (e.g., WFM layers) in subsequent operations. The sacrificial layer 272 may be on top of, and on sidewalls of, the upper channel layers 120a and the lower channel layers 120b. The sacrificial layer 272 may comprise a semiconductor material, and thus may be referred to herein as a "semiconductor sacrificial layer." The semiconductor material may comprise, for example, polysilicon, and may have an etch selectivity with respect to the channel layers 120, the sacrificial gate layers 270, and/or the sacrificial isolation layer 262.

According to some embodiments, the seventh insulating layer 214 may be between the sacrificial layer 272 and the channel layers 120. For example, the sacrificial layer 272 may contact the seventh insulating layer 214.

As shown in FIGs. 2D-2F, the sacrificial layer 272 may be etched to form openings therein. For example, the sacrificial layer 272 may be etched to expose sidewalls of the sacrificial layer 272 and portions of an upper surface of the substrate 110. In some embodiments, the etching may be reactive-ion etching (RIE). As an example, an etch mask may be formed and patterned on an uppermost surface of the sacrificial layer 272, and then the RIE may be performed while the etch mask is in place. Moreover, the sacrificial isolation layer 262 (FIGs. 2A-2C) may be removed by performing a selective etch that leaves the sacrificial gate layers 270 between the channel layers 120.

An insulating layer/material 176 that includes an MDI spacer 130 and vertical portions 132 may be formed after etching the sacrificial layer 272 and the sacrificial isolation layer 262. The spacer 130 may be formed in an opening that is formed by removing the sacrificial isolation layer 262. The vertical portions 132 may be in some of the openings that are etched in the sacrificial layer 272. Moreover, lower S/D regions 140 and upper S/D regions 150 may be formed in others of the openings that are etched in the sacrificial layer 272. Insulating layers 152, 178 may also be formed in the others of the openings, and insulating spacers 172 may be formed on sidewalls of the sacrificial gate layers 270 through the others of the openings.

In some embodiments, the S/D regions 140, 150 may be formed by epitaxial growth. For example, the lower S/D regions 140 may be epitaxially grown from the lower channel layers 120b, and the upper S/D regions 150 may be epitaxially grown from the upper channel layers 120a. According to some embodiments, the channel layers 120 may comprise silicon, and the lower S/D regions 140 and/or the upper S/D regions 150 may comprise silicon, silicon carbide, or silicon germanium.

The third insulating layer 152 may, in some embodiments, be formed between, in the vertical direction Z, the lower S/D regions 140 and upper S/D regions 150, and on an upper surface of each of the upper S/D regions 150. According to some embodiments, a planarization operation/process (e.g., chemical-mechanical planarization (CMP)) may be performed after forming the insulating layers 132, 152. Moreover, the insulating layers 132, 134 may comprise the same insulating material (e.g., SiBCN) as the spacer 130, and this insulating material may be different from that of the insulating layers 152, 214 (e.g., an oxide).

In some embodiments, the insulating spacers 172 may be formed on sidewalls of the sacrificial gate layers 270 and between, in the vertical direction Z, the channel layers 120. For example, the sacrificial gate layers 270 may be etched to form openings in the sacrificial gate layers 270 between the channel layers 120. Sidewalls of the sacrificial gate layers 270 may be exposed through the openings, and the insulating spacers 172 may be formed in the openings. The insulating spacers 172 may comprise the same insulating material (e.g., silicon nitride) as the insulating layers 112, 178, which may be different from the insulating material of the third insulating layer 152 and different from the insulating material of the insulating layers 132, 134.

As shown in FIGs. 2G-2I and 4, the sacrificial layer 272 may be etched (Block 415) (e.g., patterned/recessed) to form openings 276, 278 in an upper region of the sacrificial layer 272. The first openings 276 may remove the sacrificial layer 272 from between sidewalls of the vertical portions 132, and may thereby expose the sidewalls of the vertical portions 132. The second opening 278 may expose an upper surface of an extension portion EP of the spacer 130, where the extension portion EP is not vertically overlapped by the upper channel layers 120a. The second opening 278 may also expose sidewalls of the upper channel layers 120a. Each opening 276, 278 may also be referred to herein as a "recess" in the sacrificial layer 272. In some embodiments, the first opening 276 shown in FIG. 2H may be connected to (and/or may vertically overlap) the second opening 278 shown in FIG. 2I, as the cross-sections shown in FIGs. 2H and 2I intersect each other.

As shown in FIGs. 2J-2L and 4, an upper gate 170a (i.e., an upper gate material) may be formed (Block 420) in the first openings 276 (FIGs. 2G and 2H), in the second opening 278 (FIG. 2I), and in place of upper ones of the sacrificial gate layers 270. In some embodiments, the upper gate 170a may comprise an upper WFM layer, which may be between the upper channel layers 120a, on the exposed sidewalls of the upper channel layers 120a, and on the extension portion EP of the spacer 130, as shown in FIG. 2L. The upper WFM layer may be formed by, for example, metal deposition in the openings 276, 278, followed by a metal CMP operation/process.

As shown in FIGs. 2M-2O, an upper portion of the upper gate 170a may be recessed, thereby forming the third openings 282. The third openings 282 may expose upper sidewalls of the vertical portions 132 and/or upper sidewalls of the sacrificial layer 272.

As shown in FIGs. 2P-2R and 4, an insulating capping layer 180 may be formed (Block 425) in the third openings 282 (FIGs. 2M-2O). The insulating capping layer 180 may thus be on top of the upper gate 170a and between upper sidewalls of the vertical portions 132 and/or upper sidewalls of the sacrificial layer 272. The insulating capping layer 180 may be formed by, for example, depositing silicon nitride in the third openings 282 and then performing a CMP operation/process.

As shown in FIGs. 2S-2U, the fourth openings 284 may be formed by removing remaining (e.g., lower) portions of the sacrificial layer 272 (FIG. 2R), removing the seventh insulating layer 214 (FIG. 2Q), and removing lower ones of the sacrificial gate layers 270. As an example, the sacrificial layer 272 may be removed by a polysilicon removal operation/process, and the seventh insulating layer 214 may be removed by an oxide removal operation/process. In some embodiments, the seventh insulating layer 214 may be removed by an extra gate (EG) oxide removal operation/process. Moreover, the sacrificial gate layers 270 (FIG. 2P) may be removed from between the lower channel layers 120b, as the sacrificial gate layers 270 may have an etch selectivity relative to the lower channel layers 120b. As a result of removing the sacrificial layer 272, the sacrificial gate layers 270, and the seventh insulating layer 214, upper and lower surfaces of the lower channel layers 120b may be exposed, as may lower sidewalls of the vertical portions 132.

As shown in FIGs. 2V-2X and 4, a lower gate 170b (i.e., a lower gate material) may be formed (Block 430) in the fourth openings 284. In some embodiments, the lower gate 170b may comprise a lower WFM layer, which may be between the lower channel layers 120b. The lower WFM layer may be formed by, for example, metal deposition in the fourth openings 284, followed by a metal CMP operation/process. According to some embodiments, the lower gate 170b may be formed on a sidewall of the insulating capping layer 180 and on a side surface and a lower surface of the upper gate 170a.

According to some embodiments, the lower WFM layer of the lower gate 170b may comprise a first metal (e.g., aluminum), and the upper WFM layer of the upper gate 170a may comprise a second metal (e.g., titanium nitride) that is different from the first metal. Though omitted from view in FIGs. 2V-2X for simplicity of illustration, gate insulation layers may, according to some embodiments, be formed between each metal layer and the channel layers 120.

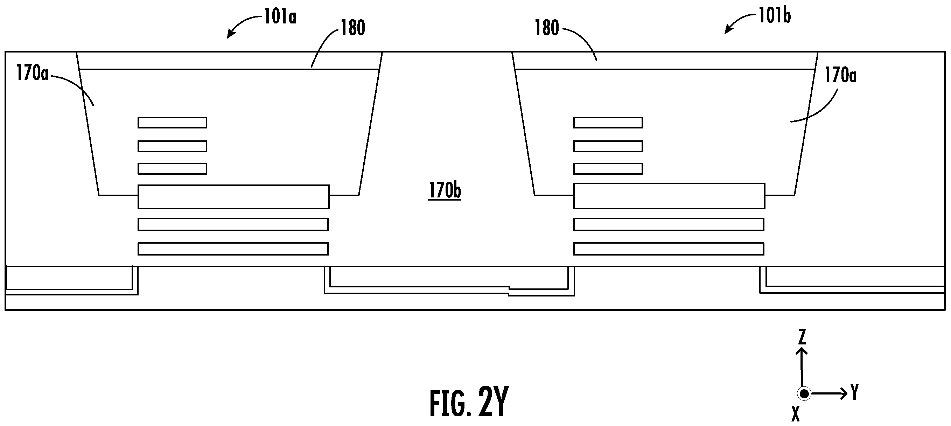

As shown in FIG. 2Y, the operations of FIGs. 2A-2X may provide multiple transistor stacks 101. For example, the lower gate 170b may be shared by a first transistor stack 101a and a second transistor stack 101b at this point in the manufacturing process. A gate-cut 160 (FIG. 1F) may subsequently be formed to electrically isolate the lower gate 170b of the first transistor stack 101a from the lower gate 170b of the second transistor stack 101b. In some embodiments, the first transistor stacks 101a and the second transistor stack 101b may each have the structure that is shown in FIG. 2X. Accordingly, each transistor stack 101a, 101b may have an insulating capping layer 180 on (e.g., on an upper surface of) an upper gate 170a.

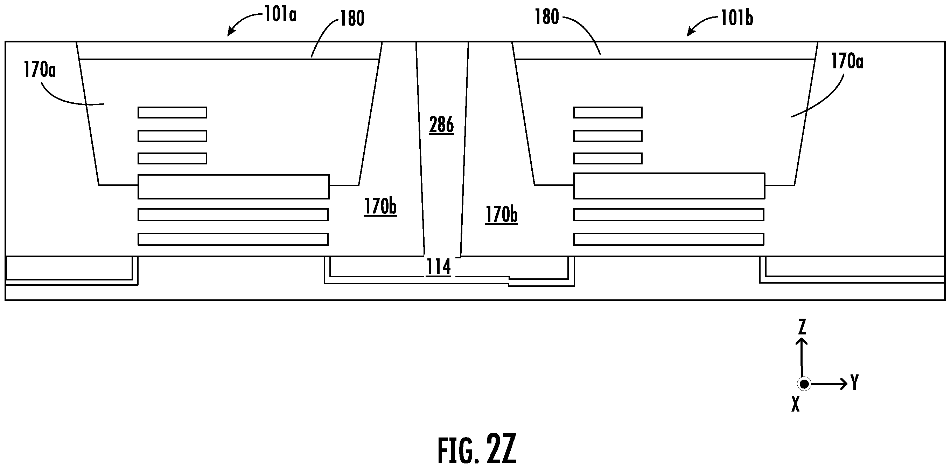

As shown in FIG. 2Z, the fifth opening 286 may be formed in the lower gate 170b between, in the second horizontal direction Y, the first transistor stack 101a and the second transistor stack 101b. The fifth opening 286 separates the lower gate 170b of the first transistor stack 101a from the lower gate 170b of the second transistor stack 101b. According to some embodiments, an upper surface of the second insulating layer 114 may be exposed by the fifth opening 286.

Referring again to FIGs. 1F and 4, a gate-cut 160 may be formed (Block 435) in the fifth opening 286 (FIG. 2Z). For example, the gate-cut 160 may be formed by forming an insulating material (e.g., silicon nitride) in the fifth opening 286. Accordingly, the gate-cut 160 can separate and electrically isolate the lower gate 170b of the first transistor stack 101a from the lower gate 170b of the second transistor stack 101b. When the opening fifth 286 is not misaligned, the structure shown in FIG. 1F may be provided after forming the gate-cut 160. On the other hand, when the fifth opening 286 is misaligned, the structure shown in FIG. 1G may be provided after forming the gate-cut 160.

The structures shown in FIGs. 1F and 1G may be referred to herein as "common gate" (rather than separated gate) structures, as a transistor stack 101 may have an upper gate 170a that is in contact with a lower gate 170b. Accordingly, the operations shown in FIGs. 2A-2Z may be referred to herein as operations for forming the "common gate" structures that are shown in FIGs. 1F and 1G.

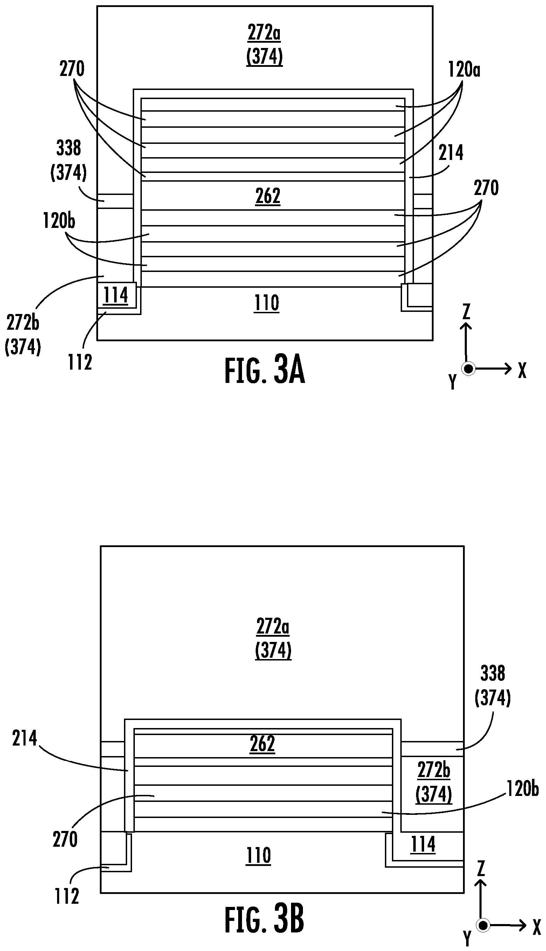

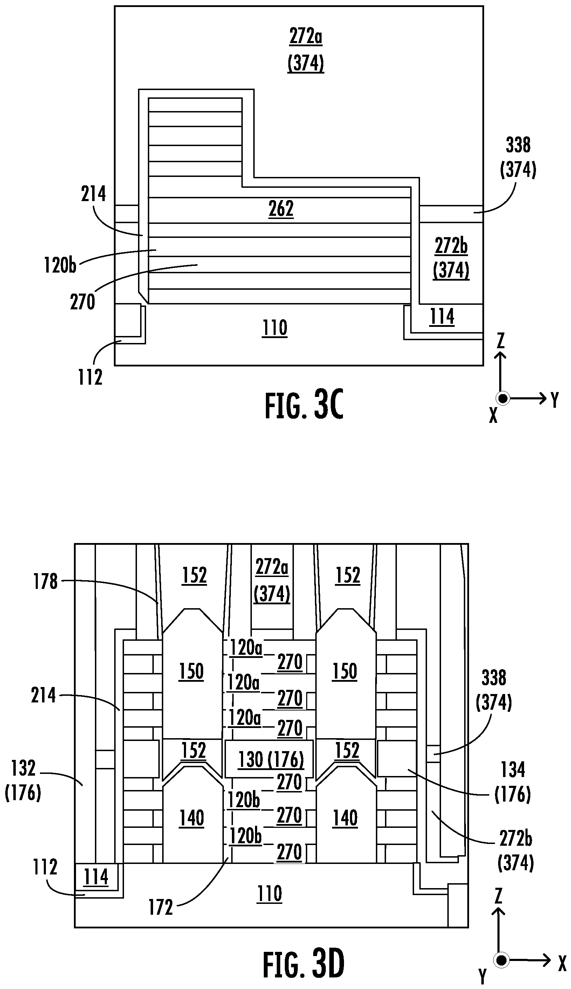

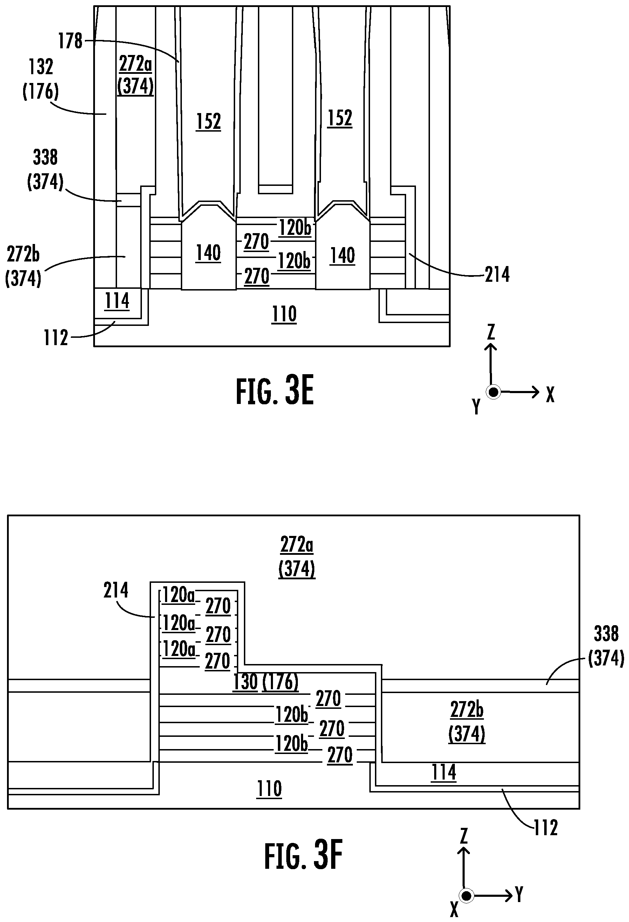

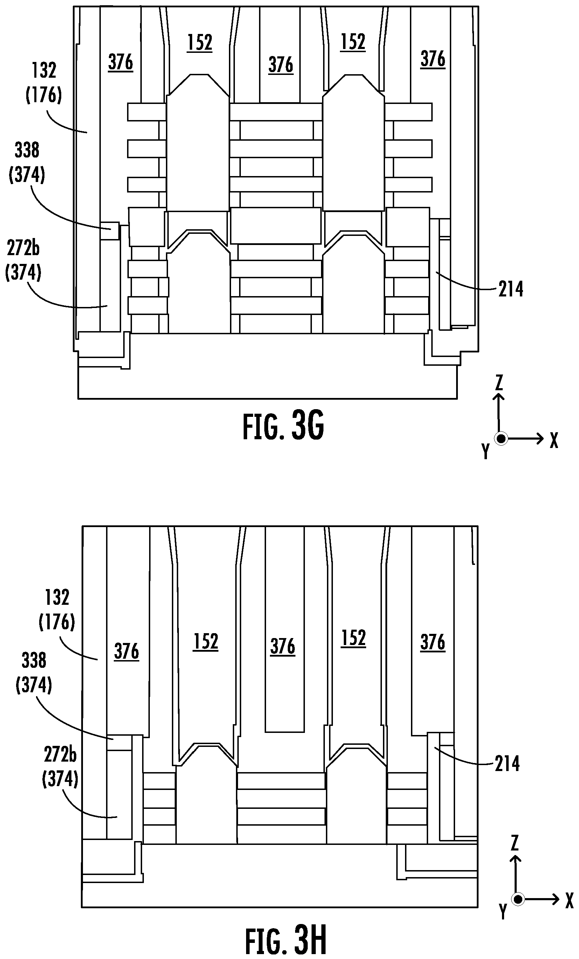

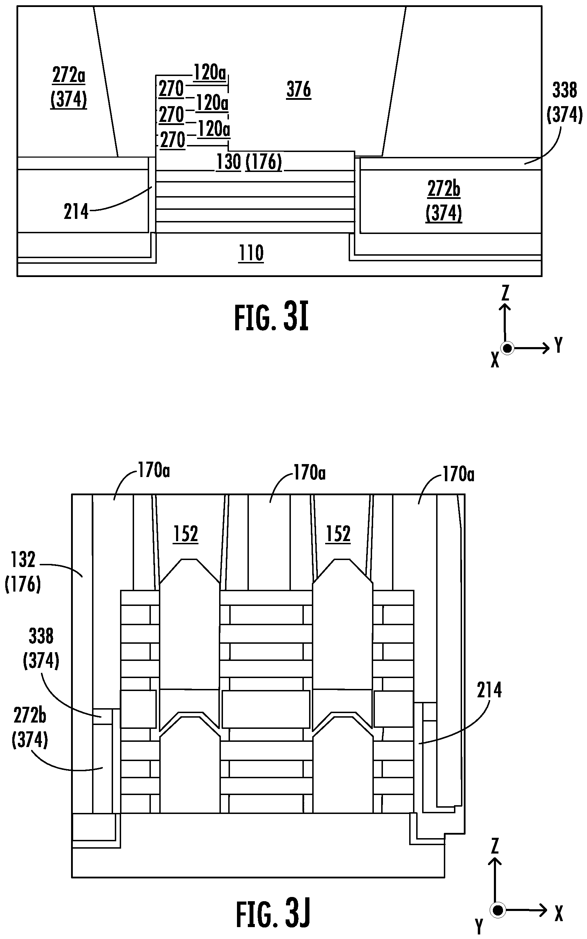

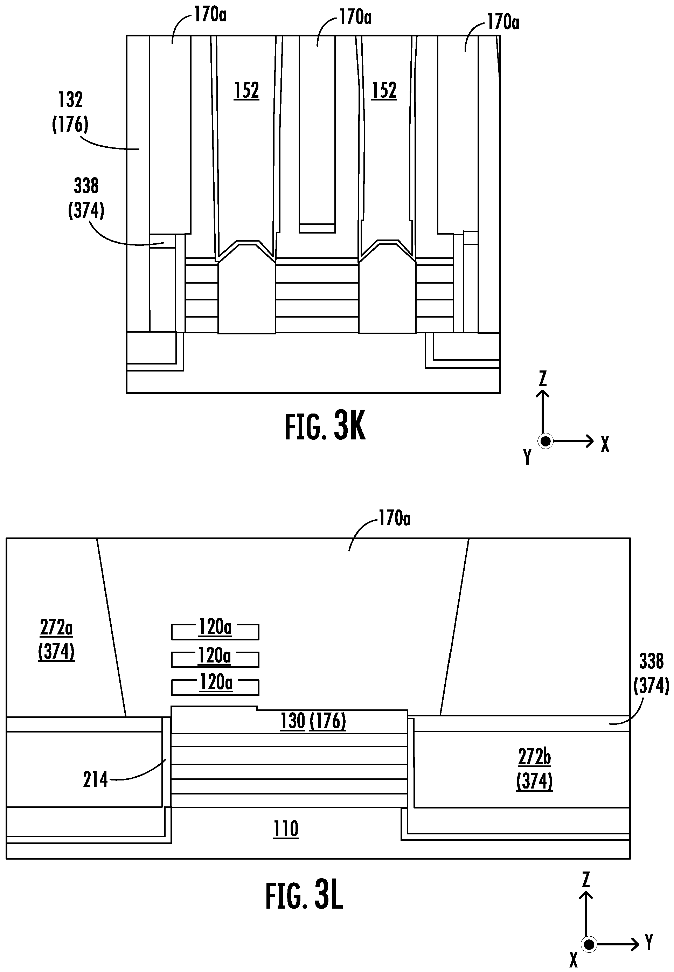

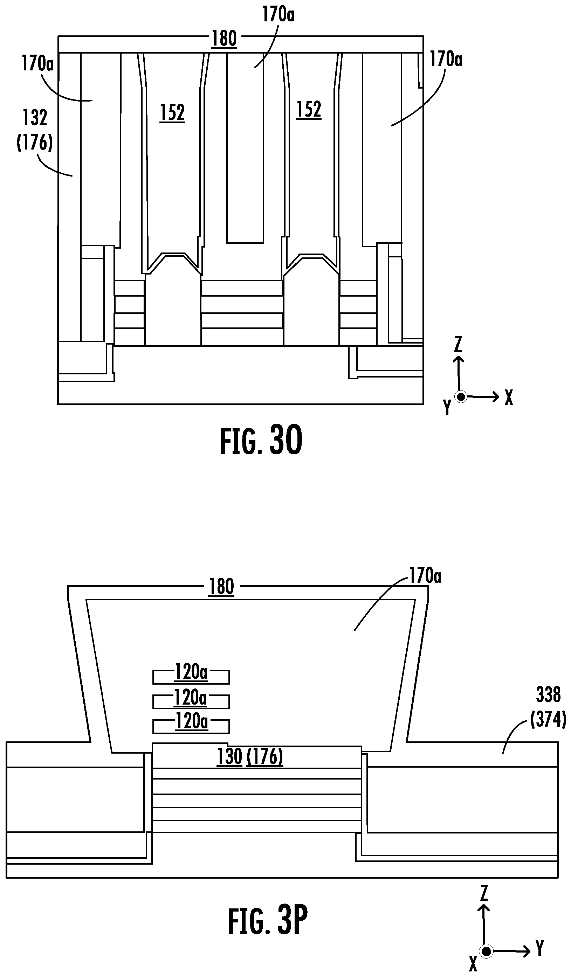

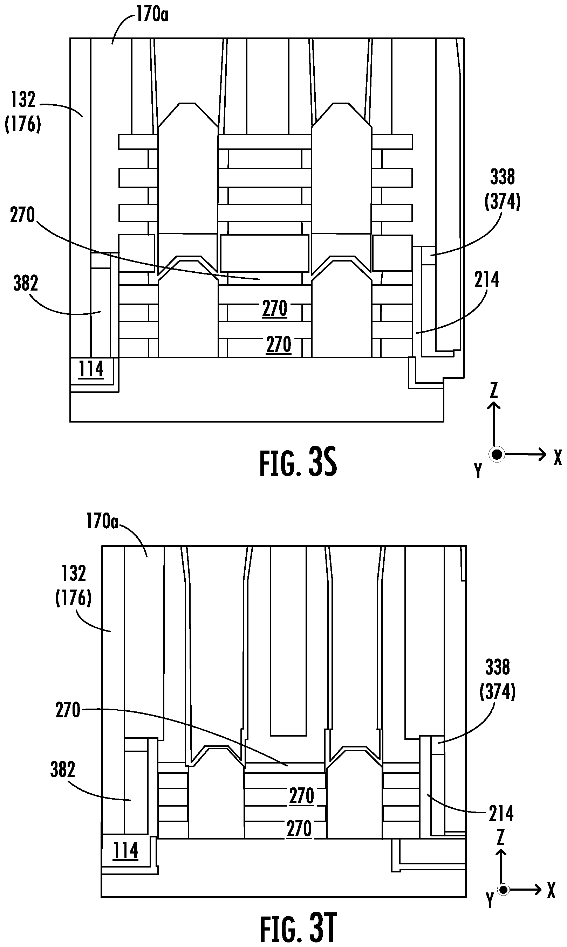

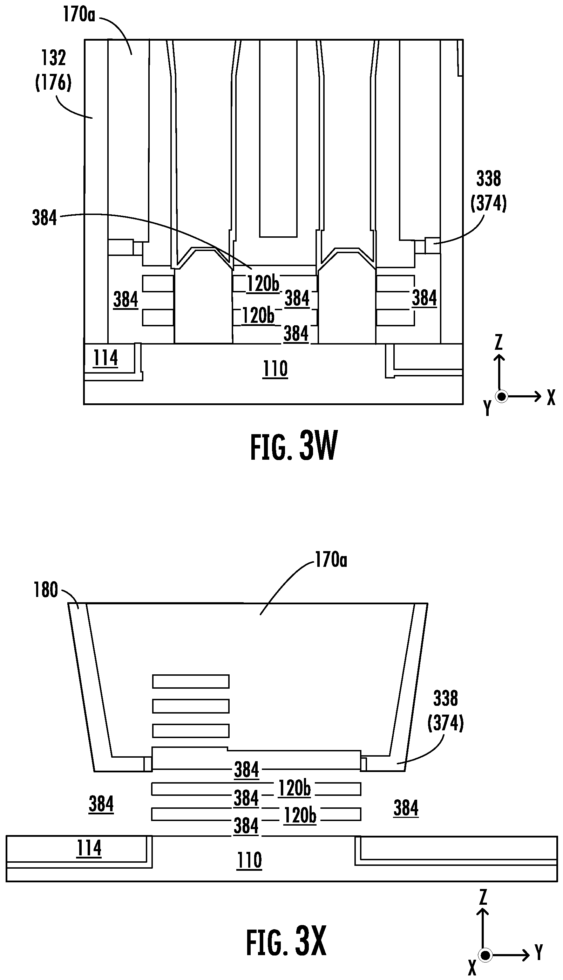

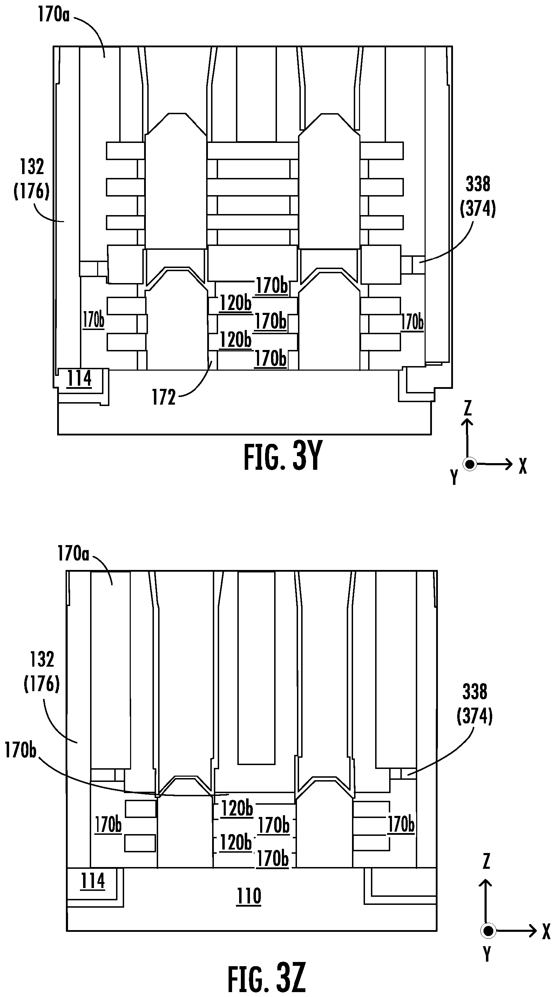

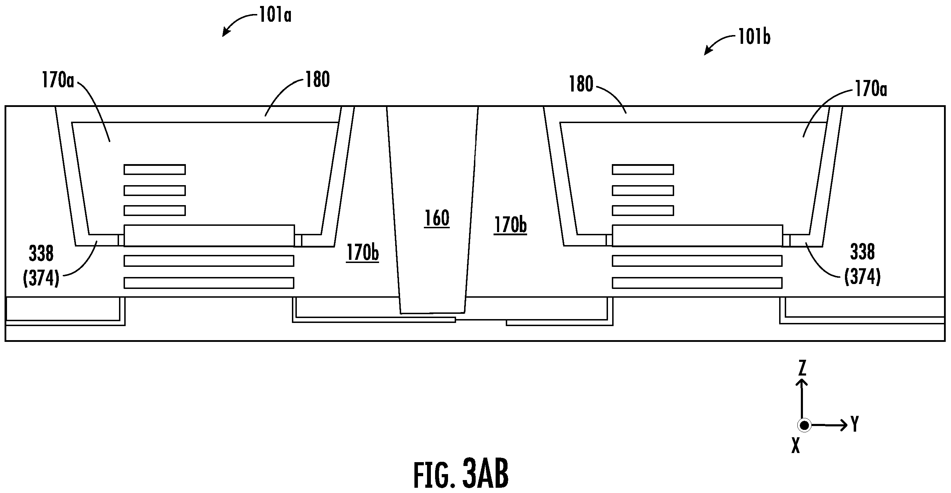

FIGs. 3A-3AC are cross-sectional views illustrating operations that are modified relative to the operations of FIGs. 2A-2Z. The operations of FIGs. 3A-3AC can be used to form transistor stacks 101 having separated gate structures in which an upper gate 170a (FIG. 3AB) does not contact a lower gate 170b (FIG. 3AB).

As shown in FIGs. 3A-3C and 4, the operations may include forming (Block 410) stacks of semiconductor channel layers 120 on a substrate 110. A multi-layer dummy gate structure 374 may then be formed on the channel layers 120. The dummy gate structure 374 may include, for example, a lower sacrificial layer 272b, an upper sacrificial layer 272a, and the eighth insulating layer 338 that is between, in the vertical direction Z, the upper sacrificial layers 272a and the lower sacrificial layer 272b 272b. Accordingly, the dummy gate structure 374 may have three layers, and thus may be referred to herein as a "tri-layer" dummy gate structure in which the eighth insulating layer 338 is the middle layer.

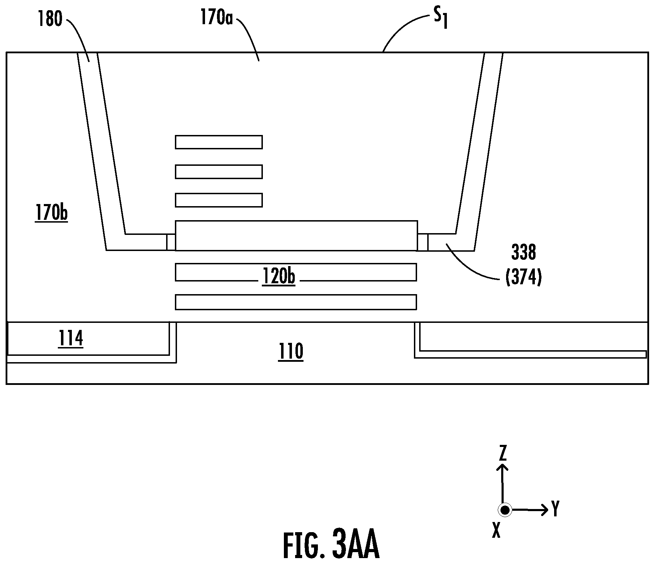

In some embodiments, the lower sacrificial layer 272b and the upper sacrificial layer 272a may include the same semiconductor material as the sacrificial layer 272 that is shown in FIGs. 2A-2C. The lower sacrificial layer 272b and the upper sacrificial layer 272a may subsequently be replaced with a lower gate 170b and an upper gate 170a (FIG. 3AA), respectively. As a result, the eighth insulating layer 338 may be between an upper surface of the lower gate 170b and a lower surface of the upper gate 170a. The eighth insulating layer 338 may comprise, for example, the same insulating material (e.g., silicon nitride) as the insulating layers 112, 178. Moreover, the eighth insulating layer 338 may be an intermediate (e.g., middle) layer of the multi-layer dummy gate structure 374 that helps when forming the upper gate 170a. As an example, the eighth insulating layer 338 may be used as an etch-stop layer when forming a recess in the dummy gate structure 374, where the upper gate 170a is subsequently formed in the recess. Though other layers of the dummy gate structure 374 may be removed after forming the recess, at least a portion of the eighth insulating layer 338 may remain. Accordingly, the transistor device 100 may include the eighth insulating layer 338 between, in the vertical direction Z, the lower gate 170b and the upper gate 170a.

As shown in FIGs. 3D-3F, a spacer 130 may be formed adjacent the eighth insulating layer 338. For example, a sidewall of the spacer 130 may overlap, in the second horizontal direction Y, a sidewall of the eighth insulating layer 338. The spacer 130 may be formed by a process/operation as described herein with respect to FIGs. 2D-2F.

As shown in FIGs. 3G-3I, the sixth openings 376 may be formed. For example, as shown in FIG. 4, the upper sacrificial layer 272a may be etched (Block 415) (e.g., patterned/recessed) to form the sixth openings 376. In some embodiments, the sixth openings 376 may expose portions of an upper surface of the eighth insulating layer 338, which may serve as an etch-stop layer when etching the upper sacrificial layer 272a. The lower sacrificial layer 272b thus may not be etched when forming the sixth openings 376.

As shown in FIGs. 3J-3L and 4, an upper gate 170a may be formed (Block 420) in the sixth openings 376 (FIGs. 3G-3I). The upper gate 170a may include an upper WFM layer, as described herein with respect to FIGs. 2J-2L. Moreover, the upper gate 170a may vertically overlap portions of the eighth insulating layer 338. For example, a lower surface of the upper gate 170a may be in contact with an upper surface of the eighth insulating layer 338.

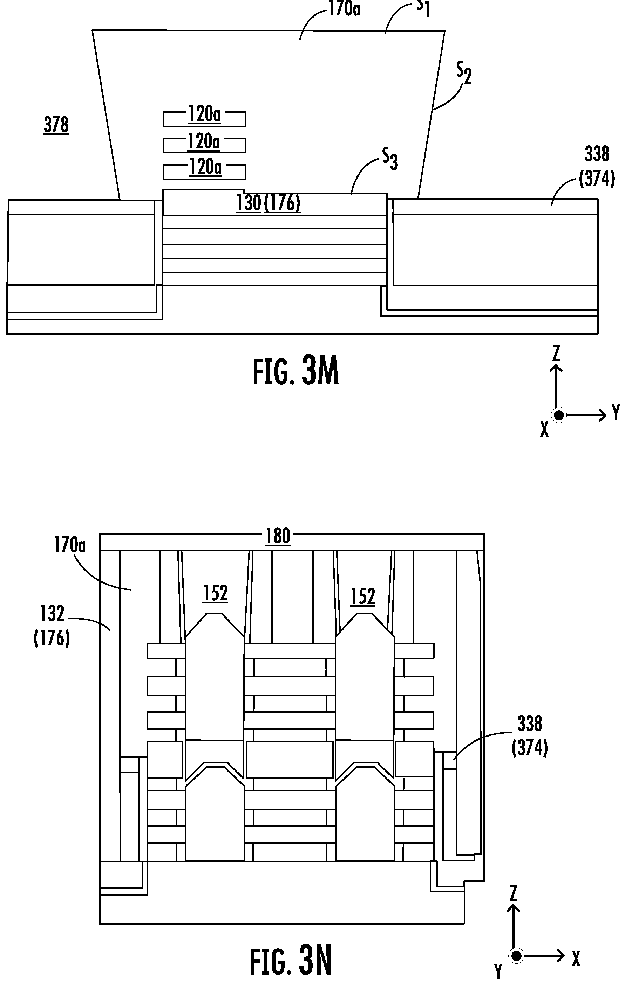

As shown in FIG. 3M, the seventh opening 378 may be formed by removing remaining portions of the upper sacrificial layer 272a, after the upper gate 170a is formed. For example, the upper sacrificial layer 272a may be removed by a polysilicon removal operation/process. The seventh opening 378 may expose an upper surface s₁ and a side surface s₂ of the upper gate 170a. The seventh opening 378 may also expose a portion of an upper surface of the eighth insulating layer 338. Moreover, a first portion of a lower surface s₃ of the upper gate 170a may be in contact with an upper surface of the spacer 130, and a second portion of the lower surface s₃ may be in contact with a portion of the upper surface of the eighth insulating layer 338 that is not exposed by the seventh opening 378.

As shown in FIGs. 3N-3P and 4, an insulating capping layer 180 may be formed (Block 425) on the upper surface s₁ (FIG. 3M) and the side surface s₂ (FIG. 3M) of the upper gate 170a. As an example, the insulating capping layer 180 may extend continuously from the upper surface s₁ of the upper gate 170a to the side surface s₂ of the upper gate 170a. In some embodiments, the insulating capping layer 180 may extend continuously from the upper surface s₁ of the upper gate 170a to the upper surface of the eighth insulating layer 338. The insulating capping layer 180 may thus be in contact with the eighth insulating layer 338.

According to some embodiments, the insulating capping layer 180 may be formed by a conformal deposition of an insulating material (e.g., silicon nitride) on the exposed upper surface s₁, the exposed side surface s₂, and the exposed portion of the upper surface of the eighth insulating layer 338. A portion of the insulating capping layer 180 that is on the side surface s₂ may be referred to herein as a "sidewall insulating layer." Moreover, the insulating capping layer 180 and the eighth insulating layer 338 may include the same insulating material (e.g., silicon nitride), and therefore may not have a visible/discernible boundary therebetween.

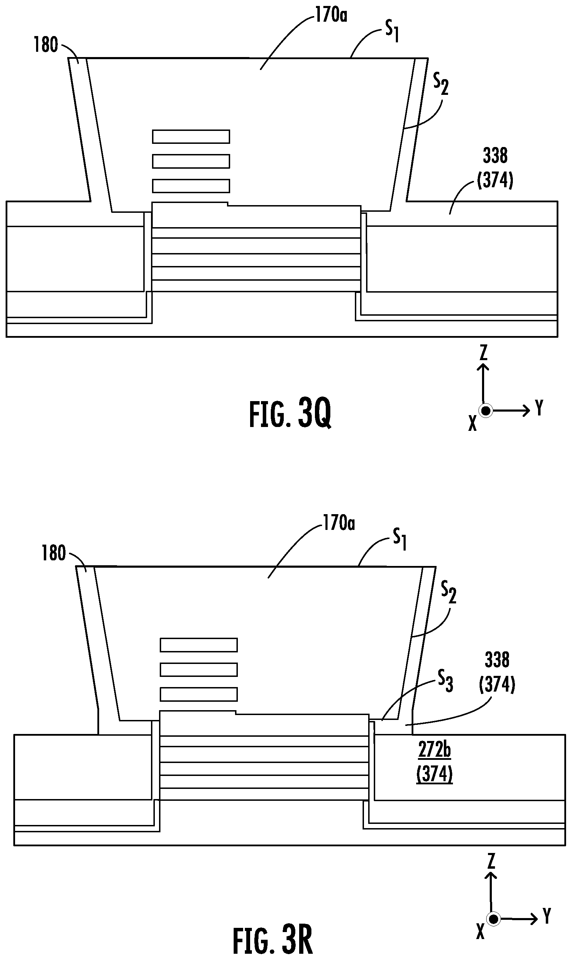

As shown in FIG. 3Q, an upper portion of the insulating capping layer 180 may be removed. As an example, the insulating capping layer 180 may be recessed to expose the upper surface s₁ of the upper gate 170a. Moreover, a horizontal portion of the insulating capping layer 180 that is on the eighth insulating layer 338 may be thinned or removed. A vertical portion of the insulating capping layer 180, however, may remain on the side surface s₂ of the upper gate 170a and may contact the eighth insulating layer 338.

As shown in FIG. 3R, a portion of the eighth insulating layer 338 that is not vertically overlapped by the upper gate 170a, and is not in contact with the vertical portion of the insulating capping layer 180, may be recessed. For example, an exposed portion of the eighth insulating layer 338 may be removed. A remaining portion of the eighth insulating layer 338 may have an upper surface including a first portion that is in contact with the lower surface s₃ of the upper gate 170a and a second portion that is in contact with a lower surface of the vertical portion of the insulating capping layer 180.

As shown in FIGs. 3S-3U, the lower sacrificial layer 272b (FIG. 3R) may be removed, thereby forming the eighth openings 382. As an example, the lower sacrificial layer 272b may be removed by a polysilicon removal operation/process. The eighth openings 382 may expose a sidewall of the seventh insulating layer 214, sidewalls of the vertical portions 132, and a lower surface of the eighth insulating layer 338.

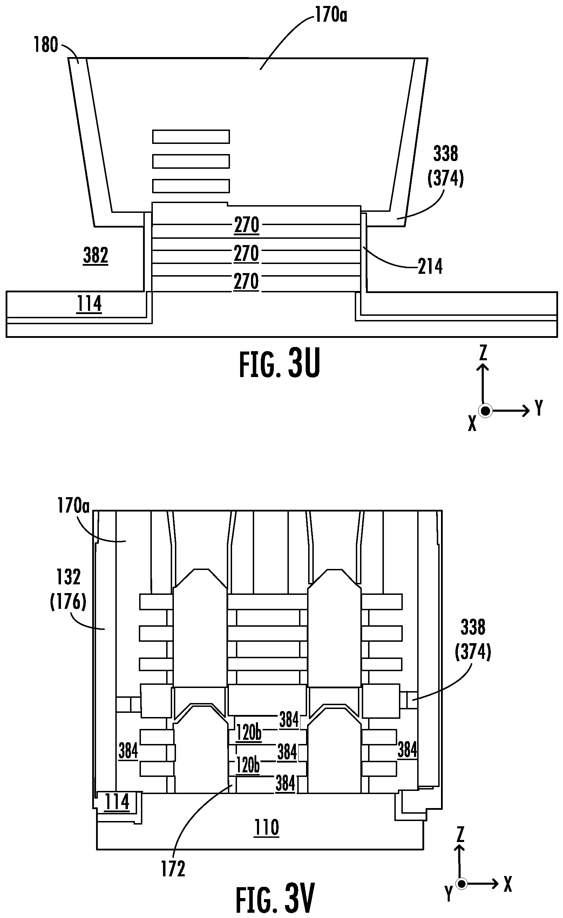

As shown in FIGs. 3V-3X, lower ones of the sacrificial gate layers 270 (FIG. 3U) may be removed, such as by selectively etching the sacrificial gate layers 270 relative to the lower channel layers 120b. The seventh insulating layer 214 may also be removed, such as by an extra gate(EG) oxide removal operation/process. As a result of removing the sacrificial gate layers 270 and the seventh insulating layer 214, the ninth openings 384 may be formed between and beside the lower channel layers 120b.

As shown in FIGs. 3Y-3AA and 4, a lower gate 170b may be formed (Block 430) in the ninth openings 384 (FIGs. 3 V-3X). The lower gate 170b may include a lower WFM layer, as described herein with respect to FIGs. 2V-2X.

The insulating capping layer 180 shown in FIG. 3AA separates (e.g., electrically isolates) the upper gate 170a from the lower gate 170b, and thus provides a separated gate structure. In other embodiments, a common gate structure may be provided according to the operations shown in FIGs. 2A-2Z. According to further embodiments, a common gate structure may be provided by removing the insulating capping layer 180 from the side surface s₂ (FIG. 3R) of the upper gate 170a after removing the lower sacrificial layer 272b (FIG. 3R).

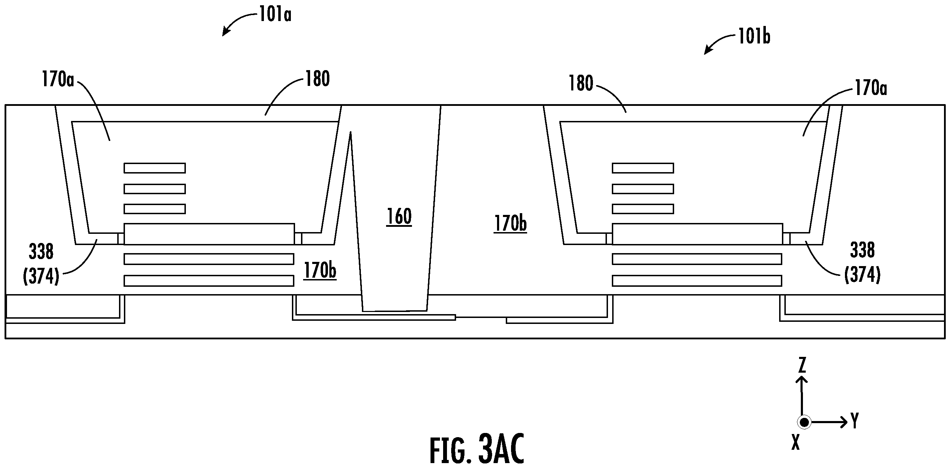

As shown in FIGs. 3AB and 3AC, the operations of FIGs. 3A-3AA may form multiple transistor stacks 101. For example, FIGs. 3AB and 3AC show a first transistor stack 101a and a second transistor stack 101b that are spaced apart from each other in the second horizontal direction Y.

Referring to FIGs. 3AB and 3AC together with FIG. 4, a gate-cut 160 may be formed (Block 435) in the lower gate 170b between the first transistor stack 101a and the second transistor stack 101b. As a result, the lower gate 170b may be separated into a lower gate 170b of the first transistor stack 101a and a lower gate 170b of the second transistor stack 101b.

FIG. 3AB illustrates a case in which the gate-cut 160 is not misaligned, and FIG. 3AC illustrates a case in which the gate-cut 160 is misaligned. When the gate-cut 160 is misaligned, it may contact a sidewall of the insulating capping layer 180.

Moreover, FIGs. 3AB and 3AC show that the insulating capping layer 180 may, in some embodiments, remain on an upper surface s₁ (FIG. 3AA) of the upper gate 170a. For example, the recessing of the insulating capping layer 180 that is shown in FIG. 3Q may be omitted. In other embodiments, unlike what is shown in FIGs. 3AB and 3AC, the insulating capping layer 180 may not be on the upper surface s₁ of the upper gate 170a.

Transistor devices 100 (FIG. 1A) according to embodiments herein may provide various advantages. These advantages include providing a self-aligned gate-cut 160 (FIG. 1F) that can reduce the risk of damage to a transistor stack 101 (FIG. 1A), and thereby help to reduce a total area of a transistor device 100 that includes the transistor stack 101. For example, the gate-cut 160 may use an upper gate 170a (FIG. 1F) (e.g., an upper WFM layer) for self-alignment such that the gate-cut 160 has adequate spacing from lower channel layers 120b (FIG. 1A) of the transistor stack 101. An insulating capping layer 180 may be on an upper surface s₁ (FIG. 1F) and/or a side surface s₂ (FIG. 3R) of the upper gate 170a, and the insulating capping layer 180 may help to laterally space the gate-cut 160 apart from channel layers 120 of the transistor stack 101, even when the gate-cut 160 is misaligned. As an example, when the insulating capping layer 180 is on the side surface s₂, a thickness of the insulating capping layer 180 can control spacing between the gate-cut 160 and channel layers 120 of the transistor stack 101.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

## Claims

1. A stacked field-effect transistor, FET, device comprising:
a lower FET (Tb) comprising lower channel layers (120b) and a lower gate material (170b) that is between the lower channel layers (120b);
an upper FET (Ta) that is on top of the lower FET (Tb), the upper FET (Ta) comprising upper channel layers (120a) and an upper gate material (170a) that is between the upper channel layers (120a); and
an insulating capping layer (180) that is on the upper gate material (170a).

2. The stacked FET device of Claim 1, wherein the insulating capping layer (180) is in contact with an upper surface of the upper gate material (170a).

3. The stacked FET device of Claim 1 or 2,
wherein the lower gate material (170b) is on a side surface of the upper gate material (170a), and
wherein the upper gate material (170a) is wider than the lower channel layers (120b).

4. The stacked FET device of any one of Claims 1 to 3, wherein the upper gate material (170a) is in contact with the lower gate material (170b).

5. The stacked FET device of any one of Claims 1 to 4, wherein the insulating capping layer (180) is on a side surface of the upper gate material (170a) and/or wherein the lower gate material (170b) is separated from the upper gate material (170a) by the insulating capping layer (180).

6. The stacked FET device of any one of Claims 1 to 5, further comprising an etch-stop layer on a lower surface of the upper gate material (170a).

7. The stacked FET device of any one of Claims 1 to 6, further comprising an isolation region (130) that separates the lower channel layers (120b) from the upper channel layers (120a),
wherein a lower surface of the upper gate material (170a) is in contact with an upper surface of the isolation region (130).

8. The stacked FET device of any one of Claims 1 to 7, further comprising a gate-cut (160) that is adjacent a side surface of the upper gate material (170a) and/or that is in contact with the insulating capping layer (180).

9. The stacked FET device of Claim 8, further comprising:
a second lower FET comprising second lower channel layers (120b) and a second lower gate material (170b) that is between the second lower channel layers (120b);
a second upper FET that is on top of the second lower FET, the second upper FET comprising second upper channel layers (120a) and a second upper gate material (170a) that is between the second upper channel layers (120a); and
a second insulating capping layer (180) that is on an upper surface of the second upper gate material (170a),
wherein the gate-cut (160) is adjacent a side surface of the second upper gate material (170a) and is between the upper gate material (170a) and the second upper gate material (170a).

10. The FET device of any one of the preceding Claims, wherein the upper gate material (170a) comprises an upper work-function metal, WFM, layer, and/or wherein the lower gate material (170b) comprises a lower WFM layer.

11. A method of forming a stacked field-effect transistor, FET, device, the method comprising:
forming (410) a nanosheet stack and a dummy gate structure on the nanosheet stack, wherein the nanosheet stack comprises lower channel layers (120b) and upper channel layers (120a) that are on the lower channel layers (120b), and wherein the dummy gate structure comprises a semiconductor sacrificial layer (272);
etching (415) the semiconductor sacrificial layer (272) to expose sidewalls of the upper channel layers (120a);
forming (420) a work-function metal, WFM, on the exposed sidewalls of the upper channel layers (120a) and between the upper channel layers (120a);
forming (425) an insulating capping layer on the WFM; and
forming (435) a gate-cut (160) adjacent a side surface of the WFM.

12. The method of Claim 11, wherein forming (425) the insulating capping layer comprises:
recessing an upper surface of the WFM; and
forming the insulating capping layer on the recessed upper surface of the WFM.

13. The method of Claim 11 or 12,
wherein the WFM is an upper WFM,
wherein the method further comprises forming a lower WFM between the lower channel layers (120b), and
wherein forming the gate-cut (160) comprises forming the gate-cut (160) in the lower WFM.

14. The method of Claim 13, wherein the lower WFM is on the side surface of the upper WFM.

15. The method of Claim 13 or 14,
wherein the semiconductor sacrificial layer is an upper semiconductor sacrificial layer,
wherein the dummy gate structure further comprises a lower semiconductor sacrificial layer and an etch-stop layer that is between the lower semiconductor sacrificial layer and the upper semiconductor sacrificial layer, before etching the semiconductor sacrificial layer, and
wherein the etch-stop layer is between the upper WFM and the lower WFM, after the upper semiconductor sacrificial layer is replaced with the upper WFM and the lower semiconductor sacrificial layer is replaced with the lower WFM.
